# EUROPEAN PATENT APPLICATION

(11) **EP 4 836 637 A2**
(43) Date of publication of application: **04.11.2026**
(21) Application number: 26175521.9
(22) Date of filing: 29.04.2026
(51) Int. Cl.: H10F 10/166, H10F 71/00, H10F 77/30

(54) **SOLAR CELL AND PREPARATION METHOD THEREFOR, AND PHOTOVOLTAIC MODULE**

(30) Priority: 29.04.2025 CN 202510554544
(71) Applicant: Tongwei Solar (Chengdu) Co., Ltd., Chengdu, Sichuan 610299 (CN)
(72) Inventor: LIU, Xu, Chengdu, Sichuan, 610299 (CN); WANG, Yongjie, Chengdu, Sichuan, 610299 (CN)
(74) Representative: Dehns Germany Partnerschaft mbB

(57) **Abstract**

The present invention relates to a solar cell and a preparation method therefor, and a photovoltaic module. The solar cell includues: an N-type semiconductor substrate, a first passivation layer, a second passivation layer, an N-type doped microcrystalline silicon layer, a P-type doped microcrystalline silicon layer, a first transparent conductive layer (105), a second transparent conductive layer, a first electrode and a second electrode; the N-type doped microcrystalline silicon layer comprises a plurality of sub-doped layers, the plurality of sub-doped layers comprise a target sub-doped microcrystalline silicon layer, and a crystallization rate of the target sub-doped microcrystalline silicon layer is in a range of 10% to 30%, a thickness of the target sub-doped microcrystalline silicon layer is in a range of 8 nm to 12 nm, and an extinction coefficient of the target sub-doped microcrystalline silicon layer is in a range of 0.25 to 0.45.

## Description

### Technical Field

The present invention relates to the field of solar energy, and in particular, to a solar cell and a preparation method therefor, and a photovoltaic module.

### Background

Heterojunction solar cells (Heterojunction with Intrinsic Thin-layer, HJT) are highly-efficient crystalline silicon solar cells, and have become the main development direction of high-efficiency cells at present and have achieved large-scale development due to their advantages such as simple fabrication process, low process temperature, high photoelectric conversion efficiency, and ease of thinning.

In existing heterojunction solar cells, a passivation layer (or an intrinsic passivation layer) is inserted between a silicon substrate and a doped microcrystalline silicon layer, so as to passivate defects on the surface of the silicon substrate and inhibit carrier recombination, thereby effectively increasing an open-circuit voltage and a fill factor and increasing the efficiency of the cell. However, the existing heterojunction solar cells may suffer from a serious problem of ultraviolet (UV) attenuation, which affects normal outdoor use. The principle of UV attenuation is that ultraviolet light (UV light) penetrates through the doped microcrystalline silicon layer and reaches the passivation layer, thereby breaking Si-H bonds of the passivation layer and forming dangling bonds, such that the passivation performance of the heterojunction solar cell is damaged. Accordingly, how to mitigate the UV attenuation of the heterojunction solar cells while ensuring the short-circuit current and the conversion efficiency of the heterojunction solar cell is a problem to be solved urgently in the art.

### Summary

On this basis, the present invention provides a solar cell and a preparation method therefor, and a photovoltaic module, which mitigates UV attenuation of heterojunction solar cells while controlling short-circuit current loss and conversion efficiency loss of the heterojunction solar cells to be within relatively low ranges.

According to a first aspect, embodiments of the present invention provide a solar cell, including:
an N-type semiconductor substrate, a first passivation layer, a second passivation layer, an N-type doped microcrystalline silicon layer, a P-type doped microcrystalline silicon layer, a first transparent conductive layer, a second transparent conductive layer, a first electrode and a second electrode, wherein the N-type semiconductor substrate includes a light-receiving surface and a backlight surface opposite each other;
the first passivation layer, the N-type doped microcrystalline silicon layer, the first transparent conductive layer and the first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and the crystallization rate of the target sub-doped microcrystalline silicon layer is in a range of 10% to 30%, the thickness of the target sub-doped microcrystalline silicon layer is in a range of 8 nm to 12 nm, and the extinction coefficient of the target sub-doped microcrystalline silicon layer is in a range of 0.25 to 0.45; and
the second passivation layer, the P-type doped microcrystalline silicon layer, the second transparent conductive layer and the second electrode are sequentially stacked on the backlight surface of the N-type semiconductor substrate.

In some embodiments of the present invention, the plurality of sub-doped layers further include: a first transition layer, located between the first passivation layer and the target sub-doped microcrystalline silicon layer, wherein the material of the first transition layer includes microcrystalline silicon doped with an N-type element.

In some embodiments of the present invention, the crystallization rate of the first transition layer is greater than the crystallization rate of the target sub-doped microcrystalline silicon layer.

In some embodiments of the present invention, the thickness of the first transition layer is in a range of 3 nm to 6 nm.

In some embodiments of the present invention, the plurality of sub-doped layers further include: a contact layer, located between the target sub-doped microcrystalline silicon layer and the first transparent conductive layer, wherein the material of the contact layer includes microcrystalline silicon which is not doped with an oxygen element and doped with an N-type element.

In some embodiments of the present invention, the crystallization rate of the target sub-doped microcrystalline silicon layer is greater than a crystallization rate of the contact layer.

In some embodiments of the present invention, the thickness of the contact layer is in a range of 2 nm to 5 nm.

In some embodiments of the present invention, the material of the target sub-doped microcrystalline silicon layer includes microcrystalline silicon doped with the oxygen element and the N-type element; and the doping concentration of the N-type element in the first transition layer is less than a doping concentration of the N-type element in the target sub-doped microcrystalline silicon layer, and the doping concentration of the N-type element in the target sub-doped microcrystalline silicon layer is less than a doping concentration of the N-type element in the contact layer.

In some embodiments of the present invention, the solar cell further includes: an N-type doped amorphous silicon layer, located between the contact layer and the first transparent conductive layer, wherein the thickness of the N-type doped amorphous silicon layer is in a range of 1 to 2 nm.

In some embodiments of the present invention, the solar cell further includes: an initial transition layer, located between the N-type doped microcrystalline silicon layer and the first passivation layer, wherein the material of the initial transition layer includes microcrystalline silicon not doped with an N-type element.

In some embodiments of the present invention, the thickness of the initial transition layer is in a range of 0.2 nm to 1 nm.

In some embodiments of the present invention, the solar cell further includes an initial transition layer and a seed layer, the seed layer is located between an initial transition layer and the first passivation layer, the initial transition layer locates between the N-type doped microcrystalline silicon layer and the first passivation layer, and the material of the seed layer includes microcrystalline silicon which is not doped with an oxygen element and an N-type element.

In some embodiments of the present invention, the thickness of the seed layer is in a range of 0.1 nm to 0.5 nm.

In some embodiments of the present invention, the first passivation layer includes a plurality of first sub-passivation layers.

In some embodiments of the present invention, the plurality of first sub-passivation layers include a first anti-epitaxial layer, a first anti-yellow-powder layer, a first main passivation layer and a first outer layer which are sequentially stacked on the light-receiving surface of the N-type semiconductor substrate; and wherein the material of the first anti-epitaxial layer, the first anti-yellow-powder layer and the first outer layer includes intrinsic amorphous silicon.

In some embodiments of the present invention, the thickness of the first anti-epitaxial layer is in a range of 0.5 nm to 3 nm, the thickness of the first anti-yellow-powder layer is in a range of 0.1 nm to 1 nm, the thickness of the first main passivation layer is in a range of 2 nm to 6 nm, and the thickness of the first outer layer is in a range of 0.5 nm to 2 nm.

In some embodiments of the present invention, the second passivation layer includes a plurality of second sub-passivation layers.

In some embodiments of the present invention, the plurality of second sub-passivation layers include a second anti-epitaxial layer, a second anti-yellow-powder layer, a second main passivation layer and a second outer layer which are sequentially stacked on the backlight surface of the N-type semiconductor substrate; wherein the material of the second anti-epitaxial layer, the second anti-yellow-powder layer and the second outer layer includes intrinsic amorphous silicon.

In some embodiments of the present invention, the thickness of the second anti-epitaxial layer is in a range of 0.5 nm to 3 nm, the thickness of the second anti-yellow-powder layer is in a range of 0.1 nm to 1 nm, the thickness of the second main passivation layer is in a range of 2 nm to 6 nm, and the thickness of the second outer layer is in a range of 0.5 nm to 2 nm.

In some embodiments of the present invention, the P-type doped microcrystalline silicon layer includes a plurality of sub-layers.

In some embodiments of the present invention, the plurality of sub-layers include a first sub-layer, a second sub-layer and a third sub-layer which are sequentially stacked on the surface of the second passivation layer away from the N-type semiconductor substrate; and the materials of the first sub-layer, the second sub-layer and the third sub-layer include a microcrystalline silicon layer doped with an oxygen element and a P-type element.

In some embodiments of the present invention, the concentrations of the P-type element in the first sub-layer, the second sub-layer and the third sub-layer gradually increase; and the thickness of the first sub-layer is in a range of 5 nm to 10 nm, the thickness of the second sub-layer is in a range of 8 nm to 15 nm, and the thickness of the third sub-layer is in a range of 8 nm to 15 nm.

In some embodiments of the present invention, the solar cell further includes a second transition layer located between the second passivation layer and the first sub-layer, wherein the material of the second transition layer is microcrystalline silicon doped with an oxygen element and not doped with a P-type element.

In a second aspect, the present invention further provides a preparation method for a solar cell, including:
an N-type semiconductor substrate is provided, wherein the N-type semiconductor substrate includes a light-receiving surface and a backlight surface opposite each other;
a first passivation layer, an N-type doped microcrystalline silicon layer, a first transparent conductive layer and a first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and the crystallization rate of the target sub-doped microcrystalline silicon layer is in a range of 10% to 30%, the thickness of the target sub-doped microcrystalline silicon layer is in a range of 8 nm to 12 nm, and the extinction coefficient of the target sub-doped microcrystalline silicon layer is in a range of 0.25 to 0.45; and a plasma-enhanced chemical vapor deposition process is used to form the target sub-doped microcrystalline silicon layer, and the pressure of process gases for forming the target sub-doped microcrystalline silicon layer is in a range of 8 Torr to 12 Torr; and
a second passivation layer, a P-type doped microcrystalline silicon layer, a second transparent conductive layer and a second electrode are sequentially stacked on the backlight surface of the N-type semiconductor substrate.

In some embodiments of the present invention, the process gases for forming the target sub-doped microcrystalline silicon layer include SiH₄, N₂O, PH₃ and H₂, a plasma ignition power is in a range of 10000 W to 15000 W, a flow ratio of SiH₄, N₂O, PH₃ and H₂ is in a range of 1:(0.5-2):(4-7):(200-250), and a plasma ignition time is in a range of 25 s to 55 s.

In some embodiments of the present invention, before the N-type doped microcrystalline silicon layer is formed, the preparation method for a solar cell further includes: a seed layer is formed on the surface of the first passivation layer away from the N-type semiconductor substrate, wherein the material of the seed layer includes microcrystalline silicon which is not doped with an oxygen element and an N-type element.

In some embodiments of the present invention, process gases used when forming the seed layer include SiH₄ and H₂, the pressure of the process gases is in a range of 4 Torr to 6 Torr, the plasma ignition power is in a range of 6000 W to 8000 W, the flow ratio of SiH₄ and H₂ is in a range of 1:(250-350), and the plasma ignition time is in a range of 2 s to 5 s.

In some embodiments of the present invention, the preparation method for a solar cell further includes:
an initial transition layer is formed on the surface of the seed layer away from the first passivation layer, wherein the material of the initial transition layer includes microcrystalline silicon not doped with an N-type element; and
the N-type doped microcrystalline silicon layer is formed on the surface of the initial transition layer away from the seed layer.

In some embodiments of the present invention, the N-type doped microcrystalline silicon layer is formed on the surface of the initial transition layer away from the seed layer, includes:
a first transition layer is formed on the surface of the initial transition layer away from the seed layer;
the target sub-doped microcrystalline silicon layer is formed on the surface of the first transition layer away from the initial transition layer; and
a contact layer is formed on the surface of the target sub-doped microcrystalline silicon layer away from the first passivation layer.

In some embodiments of the present invention, the pressure of process gases when forming the first transition layer, the target sub-doped microcrystalline silicon layer and the contact layer is greater than a pressure of process gases when forming the seed layer and the initial transition layer;
and the plasma ignition power when forming the first transition layer, the target sub-doped microcrystalline silicon layer and the contact layer is greater than a plasma ignition power when forming the seed layer and the initial transition layer;
and the hydrogen dilution ratio when forming the first transition layer, the target sub-doped microcrystalline silicon layer and the contact layer is less than a hydrogen dilution ratio when forming the seed layer and the initial transition layer.

In some embodiments of the present invention, the process gases used when forming the initial transition layer include SiH₄, N₂O and H₂, the pressure of the process gases is in a range of 4 Torr to 6 Torr, the plasma ignition power is in a range of 6000 W to 8000 W, the flow ratio of SiH₄, N₂O and H₂ is in a range of 1:(1-8):(250-350), and the plasma ignition time is in a range of 4 s to 10 s.

In some embodiments of the present invention, the process gases for forming the initial transition layer include SiH₄, N₂O, PH₃ and H₂, the pressure of the process gases is in a range of 8 Torr to 12 Torr, the plasma ignition power is in a range of 10000 W to 15000 W, the flow ratio of SiH₄, N₂O, PH₃ and Hz is in a range of 1:(0.5-2):(3-6):(250-300), and the plasma ignition time is in a range of 10 s to 25 s.

In some embodiments of the present invention, the process gases when forming the contact layer include SiH₄, PH₃ and H₂, the pressure of the process gases is in a range of 8 Torr to 12 Torr, the plasma ignition power is in a range of 10000 W to 15000 W, the flow ratio of SiH₄, PH₃ and H₂ is in a range of 1:(5-8):(200-250), and the plasma ignition time is in a range of 8 s to 25 s.

In a third aspect, the present invention further provides a preparation method for a solar cell, including:
an N-type semiconductor substrate is provided, wherein the N-type semiconductor substrate includes a light-receiving surface and a backlight surface opposite each other;
a first passivation layer, an N-type doped microcrystalline silicon layer, a first transparent conductive layer and a first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and a plasma-enhanced chemical vapor deposition process is used to form the target sub-doped microcrystalline silicon layer; process gases for forming the target sub-doped microcrystalline silicon layer include SiH₄, N₂O, PH₃ and H₂, the pressure of the process gases is in a range of 8 Torr to 12 Torr, the plasma ignition power is in a range of 10000 W to 15000 W, the flow ratio of SiH₄, N₂O, PH₃ and H₂ is in a range of 1:(0.5-2):(4-7):(200-250), and the plasma ignition time is in a range of 25 s to 55 s; and
a second passivation layer, a P-type doped microcrystalline silicon layer, a second transparent conductive layer and a second electrode are sequentially stacked on the backlight surface of the N-type semiconductor substrate.

In some embodiments of the present invention, before the N-type doped microcrystalline silicon layer is formed, the preparation method for a solar cell further includes: a seed layer is formed on the surface of the first passivation layer away from the N-type semiconductor substrate, wherein the material of the seed layer includes microcrystalline silicon which is not doped with an oxygen element and an N-type element.

In some embodiments of the present invention, process gases used when forming the seed layer include SiH₄ and H₂, the pressure of the process gases is in a range of 4 Torr to 6 Torr, the plasma ignition power is in a range of 6000 W to 8000 W, the flow ratio of SiH₄ and H₂ is in a range of 1:(250-350), and the plasma ignition time is in a range of 2 s to 5 s.

In some embodiments of the present invention, the preparation method for a solar cell further includes:
an initial transition layer is formed on the surface of the seed layer away from the first passivation layer, wherein the material of the initial transition layer includes microcrystalline silicon not doped with an N-type element; and
the N-type doped microcrystalline silicon layer is formed on the surface of the initial transition layer away from the seed layer.

In some embodiments of the present invention, the N-type doped microcrystalline silicon layer is formed on the surface of the initial transition layer away from the seed layer, includes:
a first transition layer is formed on the surface of the initial transition layer away from the seed layer;
the target sub-doped microcrystalline silicon layer is formed on the surface of the first transition layer away from the initial transition layer; and
a contact layer is formed on the surface of the target sub-doped microcrystalline silicon layer away from the first passivation layer.

In some embodiments of the present invention, the pressure of process gases when forming the first transition layer, the target sub-doped microcrystalline silicon layer and the contact layer is greater than a pressure of process gases when forming the seed layer and the initial transition layer;
and the plasma ignition power when forming the first transition layer, the target sub-doped microcrystalline silicon layer and the contact layer is greater than a plasma ignition power when forming the seed layer and the initial transition layer;
and the hydrogen dilution ratio when forming the first transition layer, the target sub-doped microcrystalline silicon layer and the contact layer is less than a hydrogen dilution ratio when forming the seed layer and the initial transition layer.

In some embodiments of the present invention, the process gases used when forming the initial transition layer include SiH₄, N₂O and H₂, the pressure of the process gases is in a range of 4 Torr to 6 Torr, the plasma ignition power is in a range of 6000 W to 8000 W, the flow ratio of SiH₄, N₂O and H₂ is in a range of 1:(1-8):(250-350), and the plasma ignition time is in a range of 4 s to 10 s.

In some embodiments of the present invention, the process gases for forming the initial transition layer include SiH₄, N₂O, PH₃ and H₂, the pressure of the process gases is in a range of 8 Torr to 12 Torr, the plasma ignition power is in a range of 10000 W to 15000 W, the flow ratio of SiH₄, N₂O, PH₃ and Hz is in a range of 1:(0.5-2):(3-6):(250-300), and the plasma ignition time is in a range of 10 s to 25 s.

In some embodiments of the present invention, the process gases when forming the contact layer include SiH₄, PH₃ and H₂, the pressure of the process gases is in a range of 8 Torr to 12 Torr, the plasma ignition power is in a range of 10000 W to 15000 W, the flow ratio of SiH₄, PH₃ and H₂ is in a range of 1:(5-8):(200-250), and the plasma ignition time is in a range of 8 s to 25 s.

In a fourth aspect, the present invention further provides a photovoltaic module, including:
cell strings, including a plurality of solar cells as described above, or including a plurality of solar cells prepared using the preparation method for a solar cell as described above.

Details of one or more embodiments of the present invention are proposed in the accompanying drawings and the description below. Other features, objects and advantages of the present invention will become apparent from the description, the accompanying drawings, and the claims.

### Brief Description of the Drawings

In order to illustrate the technical solutions of the embodiments of the present invention more clearly, hereinafter, accompanying drawings requiring to be used in the illustration of the embodiments will be briefly introduced. Apparently, the accompanying drawings in the following description merely relate to some embodiments of the present invention, and for a person of ordinary skill in the art, other accompanying drawings can also be obtained according to these accompanying drawings without involving any inventive effort.
Fig. 1 is a schematic structural diagram I of a solar cell provided according to some embodiments of the present invention.
Fig. 2 is a schematic structural diagram II of a solar cell provided according to some embodiments of the present invention.
Fig. 3 is a schematic structural diagram III of a solar cell provided according to some embodiments of the present invention.
Fig. 4 is a schematic structural diagram IV of a solar cell provided according to some embodiments of the present invention.
Fig. 5 is a schematic flowchart I of a preparation method for a solar cell provided according to some embodiments of the present invention;
Fig. 6 is a schematic flowchart II of a preparation method for a solar cell provided according to some embodiments of the present invention;
Fig. 7 is a schematic flowchart of some steps of the preparation method for a solar cell shown in Fig. 5 or Fig. 6 provided according to some embodiments of the present invention;
Fig. 8 is a schematic structural diagram after formation of an N-type semiconductor substrate provided according to some embodiments of the present invention;
Fig. 9 is a schematic structural diagram after formation of a first passivation layer and a second passivation layer provided according to some embodiments of the present invention;
Fig. 10 is a schematic structural diagram after formation of a seed layer and an initial transition layer provided according to some embodiments of the present invention;
Fig. 11 is a schematic structural diagram after formation of an N-type doped microcrystalline silicon layer provided according to some embodiments of the present invention;
Fig. 12 is a schematic structural diagram after formation of a P-type doped microcrystalline silicon layer provided according to some embodiments of the present invention;
Fig. 13 is a schematic structural diagram after formation of a first transparent conductive layer and a second transparent conductive layer provided according to some embodiments of the present invention; and
Fig. 14 is a schematic structural diagram after formation of a first electrode and a second electrode provided according to some embodiments of the present invention.

### Description of reference signs:

100 - N-type semiconductor substrate; 101 - first passivation layer; 102 - second passivation layer; 103 - N-type doped microcrystalline silicon layer; 103a - first transition layer; 103b - target sub-doped microcrystalline silicon layer; 103c - contact layer; 104 - P-type doped microcrystalline silicon layer; 105 - first transparent conductive layer (105); 106 - second transparent conductive layer; 107 - first electrode; 108 - second electrode; 109 - initial transition layer; 110 - seed layer; 111 - N-type doped amorphous silicon layer.

### Detailed Description of the Embodiments

In order to facilitate understanding of the present invention, the present invention will be described more fully hereinafter with reference to related accompanying drawings. Embodiments of the present invention are shown in the accompanying drawings. However, the present invention may be implemented in many different forms, and are not limited to the embodiments described herein. Rather, the purpose of providing these embodiments is to make the invention content of the present invention more thorough and complete.

Unless defined otherwise, all technical and scientific terms used herein have the same meanings as those commonly understood by a person of ordinary skill in the art to which the present invention belongs. The terms used herein in the description of the present invention are for the purpose of describing particular embodiments only, and are not intended to limit the present invention.

It will be understood that when an element or layer is referred to as being "on...", "adjacent to...", "connected to" or "coupled to" other elements or layers, it can be directly on, adjacent to, connected to or coupled to the other elements or layers, or intermediate elements or layers may be present. In contrast, when an element is referred to as being "directly on...", "directly adjacent to...", "directly connected to" or "directly coupled to" other elements or layers, there are no intermediate elements or layers. It will be understood that although terms first, second, third, etc., may be used to describe various elements, components, regions, layers, doping types and/or portions, these elements, components, regions, layers, doping types and/or portions should not be limited by these terms. These terms are only used to distinguish one element, component, region, layer, doping type or portion from another element, component, region, layer, doping type or portion. Thus, a first element, component, region, layer, doping type or portion discussed below could be represented as a second element, component, region, layer or portion without departing from the teachings of the present invention.

Spatial relationship terms, such as "under...", "below...", "lower", "beneath...", "above...", "upper" etc., may be used herein to describe the relationship between one element or feature and other elements or features as shown in the drawings. It will be understood that in addition to the orientations shown in the drawings, the spatial relationship terms further include different orientations of a device in use and operation. For example, if a device in the drawings is turned over, elements or features described as "under" or "beneath" or "below" other elements would then be oriented "above" the other elements or features. Thus, the exemplary terms "below..." and "under..." may include both an upper orientation and a lower orientation. In addition, the device may include additional orientations (e.g., rotated by 90 degrees or other orientations), and spatial description phrases used herein are interpreted accordingly.

As used herein, the singular forms "a", "an", and "said/the" may include plural forms as well, unless the context clearly indicates otherwise. It will be further understood that the terms "include/including" or "having" or the like, specify the presence of stated features, integers, steps, operations, components, portions, or combinations thereof, but do not preclude the possibility of the presence or addition of one or more other features, integers, steps, operations, components, portions, or combinations thereof. Also, in the present description, the term "and/or" includes any and all combinations of the associated listed items.

The structure of the embodiments of the present invention should not be limited to the particular shapes shown in the drawings of the description, but include deviations in shapes caused by e.g. manufacturing techniques.

It can be understood that in the drawings of the description of the present invention, adjacent film layers of the same film layer material processed in some figures are drawn as being connected, such that they are similar to actual structures.

In existing heterojunction solar cells, a doped microcrystalline silicon layer replaces a traditional doped amorphous silicon layer, and compared with the doped amorphous silicon layer, the doped microcrystalline silicon layer has better conductivity, higher carrier mobility and higher conversion efficiency. The crystallization rate of the doped microcrystalline silicon layer directly affects the carrier mobility and lattice defects, and in order to balance the carrier mobility and the lattice defects of the doped microcrystalline silicon layer, the existing doped microcrystalline silicon layer will maintain a high crystallization rate (typically greater than 30%, even up to 40% and higher). If the crystallization rate is too high, the doped microcrystalline silicon layer has weak absorption effect on incident short-wavelength ultraviolet light (UV light), such that ultraviolet light (UV light) penetrates through the doped microcrystalline silicon layer and reaches a passivation layer, thereby damaging Si-H bonds of the passivation layer and forming dangling bonds, such that the passivation performance of the heterojunction solar cell is damaged, and a serious UV attenuation problem is brought about. Furthermore, in existing processes, when the doped microcrystalline silicon layer is prepared, if the doped microcrystalline silicon layer includes multiple layers, the deposition pressure is almost consistent when the multiple doped microcrystalline silicon layers are prepared, and the deposition pressure is also not high, generally less than 6 Torr, such that the absorption effect of ultraviolet light (UV light) by the prepared doped microcrystalline silicon layers is also very weak.

In some embodiments, the absorption effect of ultraviolet light (UV light) by the doped microcrystalline silicon layer can be improved by reducing the crystallization rate of the doped microcrystalline silicon layer, so as to mitigate UV attenuation, but while the crystallization rate of the doped microcrystalline silicon layer is reduced, the problems of serious short-circuit current loss and conversion efficiency loss of the heterojunction solar cell will be brought about.

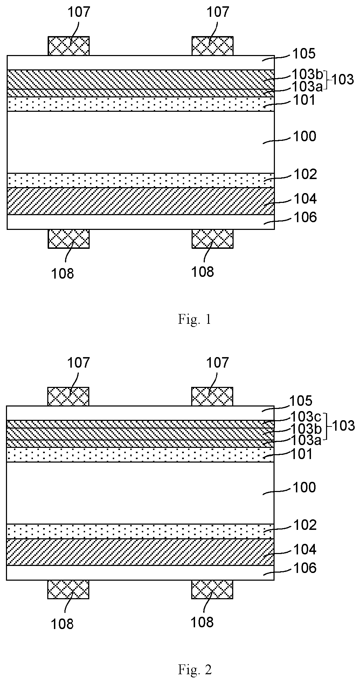

To this end, a first aspect of the present invention provides a solar cell. Fig. 1 is a schematic structural diagram of a solar cell provided according to some embodiments of the present invention. Referring to Fig. 1, the solar cell includes:
an N-type semiconductor substrate 100, a first passivation layer 101, a second passivation layer 102, an N-type doped microcrystalline silicon layer 103, a P-type doped microcrystalline silicon layer 104, a first transparent conductive layer (105) 105, a second transparent conductive layer 106, a first electrode 107 and a second electrode 108, wherein the N-type semiconductor substrate 100 includes a light-receiving surface and a backlight surface opposite each other;
the first passivation layer 101, the N-type doped microcrystalline silicon layer 103, the first transparent conductive layer (105) 105 and the first electrode 107 are sequentially stacked on the light-receiving surface of the N-type semiconductor substrate 100, wherein the N-type doped microcrystalline silicon layer 103 includes a plurality of sub-doped layers, the plurality of sub-doped layers include a target sub-doped microcrystalline silicon layer 103b, the crystallization rate of the target sub-doped microcrystalline silicon layer is in a range of 10% to 30%, the thickness of the target sub-doped microcrystalline silicon layer is in a range of 8 nm to 12 nm, and the extinction coefficient of the target sub-doped microcrystalline silicon layer is in a range of 0.25 to 0.45; and
the second passivation layer 102, the P-type doped microcrystalline silicon layer 104, the second transparent conductive layer 106 and the second electrode 108 are sequentially stacked on the backlight surface of the N-type semiconductor substrate 100.

In some embodiments, the N-type semiconductor substrate 100 serves as a main light-absorption layer of the solar cell to generate electron-hole pairs. In some embodiments, the material of the N-type semiconductor substrate 100 may be monocrystalline silicon doped with an N-type element. In some embodiments, the N-type element includes a phosphorus atom. In some other embodiments, the N-type element may also include one or more of phosphorus atom, arsenic atom or antimony atom.

The light-receiving surface of the N-type semiconductor substrate 100 is a surface on which light is incident, and the backlight surface is a surface opposite the light-receiving surface. In some embodiments, the light-receiving surface and the backlight surface of the N-type semiconductor substrate 100 have an uneven shape (not shown in the figures), so as to increase the light-absorption efficiency. In some embodiments, the uneven shape includes a V-shaped trench shape, a pyramid shape, or an inverted pyramid shape.

The first passivation layer 101 and the second passivation layer 102 are respectively used for passivating surface defects on the light-receiving surface and the backlight surface of the N-type semiconductor substrate 100 (passivating dangling bonds on the surfaces of the N-type semiconductor substrate 100 by means of hydrogen atoms), thereby inhibiting carrier recombination and increasing the conversion efficiency.

In some embodiments, the first passivation layer 101 includes a plurality of first sub-passivation layers. In some embodiments, the plurality of first sub-passivation layers include a first anti-epitaxial layer, a first anti-yellow-powder layer, a first main passivation layer and a first outer layer which are sequentially stacked on the light-receiving surface of the N-type semiconductor substrate 100; wherein the material of the first anti-epitaxial layer, the first anti-yellow-powder layer and the first outer layer includes intrinsic amorphous silicon (i-a-Si:H).

The first anti-epitaxial layer is mainly used to prevent the generation of epitaxy, if the thickness is too high, the first anti-epitaxial layer does not have an obvious effect, and on the contrary, will increase the series resistance. The first anti-yellow-powder layer plays a role of preventing the generation of yellow powder, and excessive yellow powder may affect passivation performance of the first sub-passivation layer. The first main passivation layer is a main layer of the first passivation layer 101; the first main passivation layer achieves most passivation effect in passivation, and the layer is relatively thick. The first outer layer is mainly used for enhancing the contact with the N-type doped microcrystalline silicon layer 103, reducing the series resistance of the solar cell, and increasing the fill factor of the solar cell. The first outer layer should not be too thick or too thin; and if the thickness is too high, it will affect the uniformity of the film layer and increase the series resistance, and if the thickness is too low, it will not achieve the expected effect. In some embodiments, the thickness of the first anti-epitaxial layer is in a range of 0.5 nm to 3 nm, the thickness of the first anti-yellow-powder layer is in a range of 0.1 nm to 1 nm, the thickness of the first main passivation layer is in a range of 2 nm to 6 nm, and the thickness of the first outer layer is in a range of 0.5 nm to 2 nm.

In some embodiments, the second passivation layer 102 includes a plurality of second sub-passivation layers. In some embodiments, the plurality of second sub-passivation layers include a second anti-epitaxial layer, a second anti-yellow-powder layer, a second main passivation layer and a second outer layer which are sequentially stacked on the backlight surface of the N-type semiconductor substrate 100; wherein the material of the second anti-epitaxial layer, the second anti-yellow-powder layerand the second outer layer includes intrinsic amorphous silicon (i-a-Si:H).

The second anti-epitaxial layer is mainly used to prevent the generation of epitaxy, if the thickness is too high, the second anti-epitaxial layer does not have an obvious effect, and on the contrary, will increase the series resistance. The second anti-yellow-powder layer plays a role of preventing the generation of yellow powder, and excessive yellow powder may affect passivation performance of the second sub-passivation layer. The second main passivation layer is a main layer of the second passivation layer 102; the second main passivation layer achieves most passivation effect in passivation, and the layer is relatively thick. The second outer layer is mainly used for enhancing the contact with the P-type doped microcrystalline silicon layer 104, reducing the series resistance of the solar cell, and increasing the fill factor of the solar cell. The second outer layer should not be too thick or too thin; and if the thickness is too high, it will affect the uniformity of the film layer and increase the series resistance, and if the thickness is too low, it will not achieve the expected effect. In some embodiments, the thickness of the second anti-epitaxial layer is in a range of 0.5 nm to 3 nm, the thickness of the second anti-yellow-powder layer is in a range of 0.1 nm to 1 nm, the thickness of the second main passivation layer is in a range of 2 nm to 6 nm, and the thickness of the second outer layer is in a range of 0.5 nm to 2 nm.

The main function of the N-type doped microcrystalline silicon layer is to form a surface electric field with the N-type semiconductor substrate 100, so as to facilitate transport of carriers (electrons) to the first transparent conductive layer (105). The N-type doped microcrystalline silicon layer 103 includes a plurality of sub-doped layers including the target sub-doped microcrystalline silicon layer 103b. Upon research, it has been found that relevant parameters of the target sub-doped microcrystalline silicon layer 103b have a great effect on the UV attenuation, short-circuit current and conversion efficiency. In some embodiments, if the crystallization rate of the target sub-doped microcrystalline silicon layer 103b is too high, the short-circuit current loss and the conversion efficiency loss of the solar cell will be reduced, but the UV light (ultraviolet light) penetrating through the target sub-doped microcrystalline silicon layer 103b and reaching the first passivation layer 101 will be increased, leading to very serious UV attenuation of the solar cell; and on the contrary, if the crystallization rate of the target sub-doped microcrystalline silicon layer 103b is too small, the UV light penetrating through the target sub-doped microcrystalline silicon layer 103b and reaching the first passivation layer 101 will be reduced, thus although the UV attenuation can be mitigated, the conversion efficiency loss of the solar cell will be particularly severe. If the thickness of the target sub-doped microcrystalline silicon layer 103b is too large, although the UV attenuation can be slightly mitigated, the parasitic absorption of the target sub-doped microcrystalline silicon layer 103b will be increased, leading to too large short-circuit current loss and conversion efficiency loss of the solar cell; and on the contrary, if the thickness of the target sub-doped microcrystalline silicon layer 103b is too small, although the parasitic absorption of the target sub-doped microcrystalline silicon layer 103b will be reduced, short-circuit current loss and conversion efficiency loss of the solar cell may be reduced, but it is disadvantageous to mitigate UV attenuation. If the extinction coefficient of the target sub-doped microcrystalline silicon layer 103b is too large, the absorption ratio of the target sub-doped microcrystalline silicon layer 103b to short-wavelength light will be increased, which can mitigate the UV attenuation to some extent, but may also cause aggravation of short-circuit current loss and conversion efficiency loss of the solar cell; and on the contrary, if the extinction coefficient of the target sub-doped microcrystalline silicon layer 103b is too small, the absorption ratio of the target sub-doped microcrystalline silicon layer 103b to short-wavelength light is reduced, and although this can reduce the short-circuit current loss and conversion efficiency loss of the solar cell, it is not conducive to the mitigation of UV attenuation. Accordingly, in the present invention, the crystallization rate, thickness and extinction coefficient of the target sub-doped microcrystalline silicon layer 103b in the N-type doped microcrystalline silicon layer 103 are creatively adjusted to specific ranges, such that the short-circuit current loss and conversion efficiency loss of the cell can be controlled to lower ranges while mitigating the UV attenuation. In some embodiments, the crystallization rate of the target sub-doped microcrystalline silicon layer 103b is in a range of 10% to 30%, the thickness of the target sub-doped microcrystalline silicon layer 103b is in a range of 8 nm to 12 nm, and the extinction coefficient of the target sub-doped microcrystalline silicon layer 103b is in a range of 0.25 to 0.45. When the crystallization rate of the target sub-doped microcrystalline silicon layer 103b is in a range of 10% to 30%, the proportion of amorphous silicon in the target sub-doped microcrystalline silicon layer 103b may be relatively high, such that the optical band gap of the target sub-doped microcrystalline silicon layer 103b may be narrowed, and absorption of short-wavelength ultraviolet light (or UV light) by the target sub-doped microcrystalline silicon layer 103b is enhanced, thus the ultraviolet light reaching the first passivation layer 101 can be reduced, and the damage of the ultraviolet light to Si-H bonds in the first passivation layer 101 and Si-H bonds at an interface between the first passivation layer 101 and the N-type semiconductor substrate 100 is reduced, thereby reducing the formation of dangling bonds, so as to prevent or reduce the damage of the passivation performance of the first passivation layer 101, thereby mitigating the UV attenuation. Furthermore, when the thickness of the target sub-doped microcrystalline silicon layer 103b is in a range of 8 nm to 12 nm, parasitic absorption of incident light by the target sub-doped microcrystalline silicon layer 103b can be reduced, so as to compensate for a part of the short-circuit current loss caused by the low crystallization rate of the target sub-doped microcrystalline silicon layer 103b. And when the extinction coefficient of the target sub-doped microcrystalline silicon layer 103b is in a range of 0.25 to 0.45, the transmittance of incident light (red light and infrared light with long wavelength) in the target sub-doped microcrystalline silicon layer 103b can be enhanced, so as to compensate for a part of conversion efficiency loss due to the low crystallization rate of the target sub-doped microcrystalline silicon layer 103b.

Hereinafter, the solar cell of the present invention will be further described in combination with specific examples and comparative examples, but they shall not be construed as limiting the scope of protection of the present invention.

Example 1: A solar cell, including:
an N-type semiconductor substrate 100, a first passivation layer 101, a second passivation layer 102, an N-type doped microcrystalline silicon layer 103, a P-type doped microcrystalline silicon layer 104, a first transparent conductive layer (105) 105, a second transparent conductive layer 106, a first electrode 107 and a second electrode 108, wherein the N-type semiconductor substrate 100 includes a light-receiving surface and a backlight surface opposite each other;
the first passivation layer 101, the N-type doped microcrystalline silicon layer 103, the first transparent conductive layer (105) 105 and the first electrode 107 are sequentially stacked on the light-receiving surface of the N-type semiconductor substrate 100, wherein the N-type doped microcrystalline silicon layer 103 includes a plurality of sub-doped layers, the plurality of sub-doped layers include a target sub-doped microcrystalline silicon layer 103b, the crystallization rate of the target sub-doped microcrystalline silicon layer 103b is 25%, the thickness of the target sub-doped microcrystalline silicon layer 103b is 10 nm, and the extinction coefficient of the target sub-doped microcrystalline silicon layer 103b is 0.30; and
the second passivation layer 102, the P-type doped microcrystalline silicon layer 104, the second transparent conductive layer 106 and the second electrode 108 are sequentially stacked on the backlight surface of the N-type semiconductor substrate 100.

Example 2: A solar cell, which mainly differs from Example 1 in that: the crystallization rate of the target sub-doped microcrystalline silicon layer 103b is 30%, the thickness of the target sub-doped microcrystalline silicon layer 103b is 8 nm, and the extinction coefficient of the target sub-doped microcrystalline silicon layer 103b is 0.25.

Example 3: A solar cell, which mainly differs from Example 1 in that: the crystallization rate of the target sub-doped microcrystalline silicon layer 103b is 20%, the thickness of the target sub-doped microcrystalline silicon layer 103b is 10 nm, and the extinction coefficient of the target sub-doped microcrystalline silicon layer 103b is 0.36.

Example 4: A solar cell, which mainly differs from Example 1 in that: the crystallization rate of the target sub-doped microcrystalline silicon layer 103b is 10%, the thickness of the target sub-doped microcrystalline silicon layer 103b is 12 nm, and the extinction coefficient of the target sub-doped microcrystalline silicon layer 103b is 0.45.

Comparative Example 1: A solar cell, which mainly differs from Example 1 in that: the crystallization rate of the target sub-doped microcrystalline silicon layer 103b is 35%, the thickness of the target sub-doped microcrystalline silicon layer 103b is 10 nm, and the extinction coefficient of the target sub-doped microcrystalline silicon layer 103b is 0.20.

Comparative Example 2: A solar cell, which mainly differs from Example 1 in that: the crystallization rate of the target sub-doped microcrystalline silicon layer 103b is 25%, the thickness of the target sub-doped microcrystalline silicon layer 103b is 6 nm, and the extinction coefficient of the target sub-doped microcrystalline silicon layer 103b is 0.29.

Comparative Example 3: A solar cell, which mainly differs from Example 1 in that: the crystallization rate of the target sub-doped microcrystalline silicon layer 103b is 25%, the thickness of the target sub-doped microcrystalline silicon layer 103b is 15 nm, and the extinction coefficient of the target sub-doped microcrystalline silicon layer 103b is 0.31.

Comparative Example 4: A solar cell, which mainly differs from Example 1 in that: the crystallization rate of the target sub-doped microcrystalline silicon layer 103b is 8%, the thickness of the target sub-doped microcrystalline silicon layer 103b is 10 nm, and the extinction coefficient of the target sub-doped microcrystalline silicon layer 103b is 0.48.

The UV attenuation, short-circuit current loss and conversion efficiency loss of the solar cells in Examples 1-4 and Comparative Examples 1-4 were tested, and related parameters of the target sub-doped microcrystalline silicon layer and corresponding test results in Examples 1-4 and Comparative Examples 1-4 are shown in Table 1.

**Table 1:**

| Item | Crystallization rate (%) | Thickness (nm) | Extinction coefficient | UV60 attenuation (%) | Short-circuit current loss (mA) | Conversion efficiency loss (%) |
|---|---|---|---|---|---|---|
| Example 1 | 25 | 10 | 0.30 | 1.45 | 12 | 0.03 |
| Example 2 | 30 | 8 | 0.25 | 1.68 | 8 | 0.02 |
| Example 3 | 20 | 10 | 0.36 | 1.42 | 20 | 0.06 |
| Example 4 | 10 | 12 | 0.45 | 1.35 | 32 | 0.10 |
| Comparative Example 1 | 35 | 10 | 0.20 | 2.01 | 2 | 0.00 |
| Comparative Example 2 | 25 | 6 | 0.29 | 1.75 | 42 | 0.13 |
| Comparative Example 3 | 25 | 15 | 0.31 | 1.70 | 40 | 0.12 |
| Comparative Example 4 | 8 | 10 | 0.48 | 1.30 | 45 | 0.14 |

The UV60 attenuation in Table 1 represents the attenuation of the performance of the solar cells under test conditions with an ultraviolet radiation level of 60 kWh/m².

It can be determined from Table 1 that, by using the solar cells in the embodiments of the present invention, the UV attenuation thereof is mitigated (less than or equal to 1.68%), and the short-circuit current loss (less than or equal to 32 mA) and the conversion efficiency loss (less than or equal to 0.1%) of the solar cells can be controlled in relatively low ranges. By comparing Comparative Examples 1-4 with Examples 1-4, it can be determined that when only one or two parameters among crystallization rate, extinction coefficient and thickness are within the ranges in the present invention, two undesirable situations may occur. The first situation: the UV attenuation of the solar cell is mitigated, but the short-circuit current loss and the conversion efficiency loss are relatively serious; and the second situation: the short-circuit current loss and the conversion efficiency loss of the solar cell can be controlled within relatively small ranges, but the UV attenuation is severe.

Further, the material of the target sub-doped microcrystalline silicon layer 103b includes microcrystalline silicon (µc-Si:H) doped with an oxygen element and an N-type element. In some embodiments, the N-type element includes a phosphorus atom. In some other embodiments, the N-type element may also include one or more of phosphorus atom, arsenic atom or antimony atom.

In some embodiments, with continued reference to Fig. 1, in addition to the target sub-doped microcrystalline silicon layer 103b, the plurality of sub-doped layers further include: a first transition layer 103a, located between the first passivation layer 101 and the target sub-doped microcrystalline silicon layer 103b, wherein the material of the first transition layer 103a includes microcrystalline silicon (µc-Si:H) doped with an N-type element. In some embodiments, the N-type element includes a phosphorus atom. In some other embodiments, the N-type element may also include one or more of phosphorus atom, arsenic atom or antimony atom. The thickness of the first transition layer 103a is usually small, and is less than the thickness of the target sub-doped microcrystalline silicon layer 103b. In some embodiments, the thickness of the first transition layer 103a is in a range of 3 nm to 6 nm.

In some embodiments, in addition to the first transition layer 103a and the target sub-doped microcrystalline silicon layer 103b, the plurality of sub-doped layers further include: a contact layer 103c, located between the target sub-doped microcrystalline silicon layer 103b and the first transparent conductive layer (105) 105, wherein the material of the contact layer 103c includes microcrystalline silicon (µc-Si:H) which is not doped with an oxygen element and doped with an N-type element. In some embodiments, the N-type element includes a phosphorus atom. In some other embodiments, the N-type element may also include one or more of phosphorus atom, arsenic atom or antimony atom. The function of the contact layer 103c is to achieve better contact with the first transparent conductive layer (105), so as to reduce the contact resistance. The thickness of the contact layer 103c is generally small, and is less than the thickness of the target sub-doped microcrystalline silicon layer 103b. In some embodiments, the thickness of the contact layer 103c is in a range of 2 nm to 5 nm.

In some embodiments, referring to Fig. 2, the N-type element doped in the first transition layer 103a, the target sub-doped microcrystalline silicon layer 103b and the contact layer 103c are the same, e.g. they are all phosphorus atoms; and the concentration of the N-type element in the first transition layer 103a is less than the concentration of the N-type element in the target sub-doped microcrystalline silicon layer 103b, and the concentration of the N-type element in the target sub-doped microcrystalline silicon layer 103b is less than the concentration of the N-type element in the contact layer 103c. The concentrations of the N-type element in the plurality of sub-doped layers (the first transition layer 103a, the target sub-doped microcrystalline silicon layer 103b and the contact layer 103c) in the N-type doped microcrystalline silicon layer 103 change in a gradient as described above, which facilitates the construction of a built-in electric field, facilitates the targeted transmission of carriers (electrons), and reduces recombination. Furthermore, in the contact layer 103c close to the first transparent conductive layer (105) 105, the N-type element has the highest concentration and an oxygen element is not doped, which facilitates optimization of the contact performance between the contact layer 103c and the first transparent conductive layer (105) 105 while improving the conductivity of the contact layer 103c itself, such that the contact layer 103c is in better contact with the first transparent conductive layer (105) 105 to reduce the contact resistance, thus carriers (electrons) are transported to the first transparent conductive layer (105) 105 more efficiently.

In some embodiments, the crystallization rate of the first transition layer 103a is greater than the crystallization rate of the target sub-doped microcrystalline silicon layer 103b, and the crystallization rate of the target sub-doped microcrystalline silicon layer 103b is greater than the crystallization rate of the contact layer 103c; and the first transition layer 103a close to the first passivation layer 101 requires a high crystallization rate to realize high optical performance, while the contact layer 103c close to the first transparent conductive layer (105) 105 requires high doping so as to improve the conductivity and enable carriers to be more efficiently transported to the first transparent conductive layer (105) 105, furthermore, the high doping also helps to optimize the contact performance between the contact layer 103c and the first transparent conductive layer (105) 105.

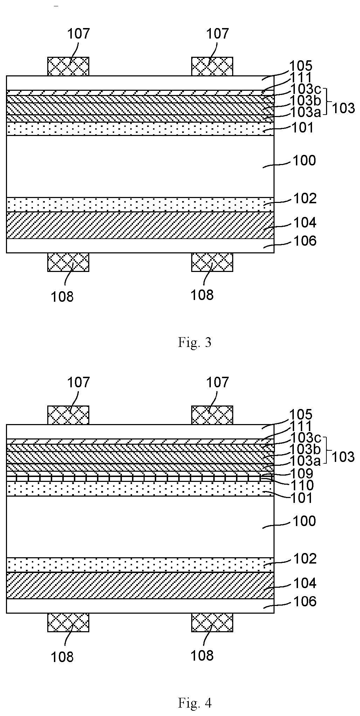

In some embodiments, referring to Fig. 3, the solar cell further includes: an N-type doped amorphous silicon layer 111, located between the contact layer 103c and the first transparent conductive layer (105) 105, wherein the thickness of the N-type doped amorphous silicon layer 111 is in a range of 1 to 2nm. The N-type doped amorphous silicon layer 111 has a relatively small thickness and has a relatively small effect on the mobility of carriers; however, the N-type doped amorphous silicon layer 111 has a relatively strong absorption capability for ultraviolet light (UV light). By means of the cooperation of the N-type doped amorphous silicon layer 111 and the N-type doped microcrystalline silicon layer 103, the ultraviolet light (UV light) can be absorbed by multiple layers, and the absorption capability for ultraviolet light (UV light) is improved, so as to further mitigate the UV attenuation of the solar cell. The N-type doped amorphous silicon layer 111 has a strong absorption capacity for ultraviolet light (UV light), and has a better absorption capacity for ultraviolet light (UV light) than the absorption capacity for ultraviolet light (UV light) of a microcrystalline silicon material. The reasons therefor are: 1. The atomic arrangement in amorphous silicon is disordered, forming localized band tails (Urbach tail states), and these band tails extend to the inside of the band gap of the amorphous silicon; and the photon energy of the ultraviolet light (UV light) is far higher than the optical band gap of the amorphous silicon, and can excite electronic transition with a higher energy level, but the continuous distribution of band tails still allows for absorption of ultraviolet light (UV light) rather than reflection or transmission of ultraviolet light (UV light) due to the sharp cutoff of the energy band structure. 2. Defect-state enhanced absorption: the doping process disrupts atomic bonding, increases the density of dangling bonds, and creates defects; and these defects introduce deep-energy-level transition channels in a band gap, for example, by means of transition from a valence band to a defect state or from a defect state to a conduction band, absorption of high-energy ultraviolet light (UV light) is significantly improved. 3. High-absorption-coefficient characteristic of amorphous silicon: the absorption coefficient of amorphous silicon is particularly high in the range of ultraviolet light (UV light) (300 nm to 400 nm).

In some embodiments, referring to Fig. 4, the solar cell further includes: a seed layer 110, located between an initial transition layer 109 and the first passivation layer 101, wherein the material of the seed layer 110 includes microcrystalline silicon which is not doped with an oxygen element and an N-type element; and the initial transition layer 109, located between the N-type doped microcrystalline silicon layer 103 and the first passivation layer 101 and located between the seed layer 110 and the N-type doped microcrystalline silicon layer 103, wherein the material of the initial transition layer 109 includes microcrystalline silicon which is not doped with an N-type element.

The function of the seed layer 110 is: to make the growth of microcrystalline silicon more orderly when the N-type doped microcrystalline silicon layer 103 is formed, thus the compactness of the formed N-type doped microcrystalline silicon layer 103 is improved, and in particular, the compactness of the target sub-doped microcrystalline silicon layer 103b is improved, and the extinction coefficient of the target sub-doped microcrystalline silicon layer 103b is reduced, thereby enhancing the transmittance of long-wavelength incident light (such as red light and infrared light) in the target sub-doped microcrystalline silicon layer 103b. Furthermore, the seed layer 110 is not doped with an oxygen element or a phosphorus element. The purpose of the seed layer 110 being not doped with the oxygen element is: the seed layer 110 is in direct contact with the first passivation layer 101, and adding the oxygen element will lead to poor contact performance of the seed layer 110 and the first passivation layer 101; and the purpose of not doping the phosphorus element is: the seed layer being doped with the phosphorus element will inhibit the crystallization process of microcrystalline silicon, resulting in an increase in the proportion of an amorphous phase (a-Si:H), hinder the growth of a microcrystalline phase with stronger conductivity, and reduce the carrier mobility; and the seed layer 110 being not doped with the phosphorus element will promote the crystallization. Furthermore, if the seed layer 110 is doped with the phosphorus element, the phosphorus element may diffuse into the first passivation layer 101, thereby affecting the passivation performance of the first passivation layer 101. The diffusion of the phosphorus element, may also cause an anomalous energy band at an interface, thereby reducing the electric field intensity and affecting the carrier transport efficiency. In addition, the undoped seed layer 110 is more likely to form a fine and uniform crystal nucleus, thereby reducing lattice defects, and laying a foundation for the subsequent deposition of the N-type doped microcrystalline silicon layer 103 with a specific crystallization rate and high conductivity.

The seed layer 110 will typically be thin. In some embodiments, the thickness of the seed layer 110 is in a range of 0.1 nm to 0.5 nm. A too thick seed layer 110 will lead to increased series resistance and reduced short-circuit current.

The function of the initial transition layer 109 is to serve as a carrier for depositing the first transition layer 103a and the target sub-doped microcrystalline silicon layer 103b. By designing the seed layer 110 and the initial transition layer 109, the first transition layer 103a can grow well, such that the target sub-doped microcrystalline silicon layer 103b can grow well.

The thickness of the initial transition layer 109 is small, and in some embodiments, the thickness of the initial transition layer 109 is in a range of 0.2 nm to 1 nm.

With continued reference to any one of Figs. 1-4, the P-type doped microcrystalline silicon layer 104 is used for forming a heterojunction with the N-type semiconductor substrate 100, so as to selectively collect holes and reduce the contact resistance. In some embodiments, the material of the P-type doped microcrystalline silicon layer 104 is microcrystalline silicon doped with a P-type element, and the P-type element includes boron atoms.

In some embodiments, the P-type doped microcrystalline silicon layer 104 includes a plurality of sub-layers. In some embodiments, the plurality of sub-layers include a first sub-layer, a second sub-layer and a third sub-layer which are sequentially stacked on the surface of the second passivation layer 102 away from the N-type semiconductor substrate 100; and the materials of the first sub-layer, the second sub-layer and the third sub-layer include a microcrystalline silicon layer doped with an oxygen element and a P-type element. In some embodiments, the concentrations of the P-type element in the first sub-layer, the second sub-layer and the third sub-layer gradually increase; and the thickness of the first sub-layer is in a range of 5 nm to 10 nm, the thickness of the second sub-layer is in a range of 8 nm to 15 nm, and the thickness of the third sub-layer is in a range of 8 nm to 15 nm.

In some embodiments, the solar cell further includes a second transition layer (not shown in the figures) located between the second passivation layer 102 and the first sub-layer, wherein the material of the second transition layer is microcrystalline silicon doped with an oxygen element and not doped with a P-type element.

With continued reference to any one of Figs. 1-4, the first transparent conductive layer (105) 105 and the second transparent conductive layer 106 are used for reducing the series resistance when collecting current, and reduce light reflection. In some embodiments, the material of the first transparent conductive layer (105) 105 and the second transparent conductive layer 106 includes indium tin oxide (ITO) or ZnO.

With continued reference to any one of Figs. 1-4, the first electrode 107 and the second electrode 108 are used for collecting current. In some embodiments, the first electrode 107 and the second electrode 108 are finger lines to reduce light shielding. The materials of the first electrode 107 and the second electrode 108 include silver (Ag) or copper (Cu).

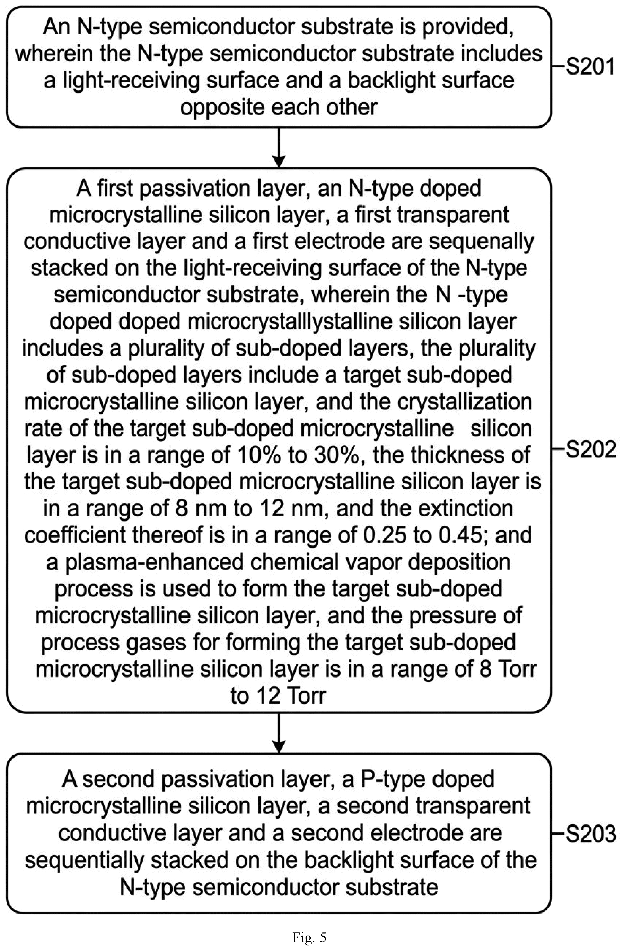

A second aspect of embodiments of the present invention also provides a preparation method for a solar cell. Referring to Fig. 5, the preparation method includes:
step S201: an N-type semiconductor substrate is provided, wherein the N-type semiconductor substrate includes a light-receiving surface and a backlight surface opposite each other;
step S202: a first passivation layer, an N-type doped microcrystalline silicon layer, a first transparent conductive layer (105) and a first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and the crystallization rate of the target sub-doped microcrystalline silicon layer is in a range of 10% to 30%, the thickness of the target sub-doped microcrystalline silicon layer is in a range of 8 nm to 12 nm, and the extinction coefficient thereof is in a range of 0.25 to 0.45; and a plasma-enhanced chemical vapor deposition process is used to form the target sub-doped microcrystalline silicon layer, and the pressure of process gases for forming the target sub-doped microcrystalline silicon layer is in a range of 8 Torr to 12 Torr; and
step S203: a second passivation layer, a P-type doped microcrystalline silicon layer, a second transparent conductive layer and a second electrode are sequentially stacked on the backlight surface of the N-type semiconductor substrate.

In the preparation method of the present embodiment, the crystallization rate of the formed target sub-doped microcrystalline silicon layer is in a range of 10% to 30%, the thickness thereof is in a range of 8 nm to 12 nm, and the extinction coefficient thereof is in a range of 0.25 to 0.45. The target sub-doped microcrystalline silicon layer of the particular parameters can control the short-circuit current loss and the conversion efficiency loss of the solar cell in relatively low ranges while mitigating the UV attenuation (reference can be made to the corresponding paragraphs in the previous embodiments for detailed illustration, and they will not be repeated herein again). A plasma-enhanced chemical vapor deposition process is used to form the target sub-doped microcrystalline silicon layer, and the pressure of process gases for forming the target sub-doped microcrystalline silicon layer is in a range of 8 Torr to 12 Torr (which is greater than the current process gas pressure, i.e. 6 Torr). Namely, in the present invention, a high process gas pressure is used to form the target sub-doped microcrystalline silicon layer, and atomic arrangement will become disordered under the high process gas pressure, and the etching effect of H atoms will be weakened; and at this time, Si atoms and H atoms will be bonded to form more amorphous structures, thus the proportion of the amorphous structures in the target sub-doped microcrystalline silicon layer becomes high, and the optical band gap of the target sub-doped microcrystalline silicon layer becomes narrow, and the crystallization rate of the formed target sub-doped microcrystalline silicon layer will be reduced (the crystallization rate is in a range of 10% to30%); and by using the high process gas pressure, compared with adjusting other process parameters, it is easier to reduce the crystallization rate of the target sub-doped microcrystalline silicon layer. Furthermore, under the high process gas pressure, hydrogen atoms are more effectively bonded to silicon dangling bonds so as to passivate grain boundaries and lattice defects; and when irradiated by ultraviolet light (UV light), the Si-H bonds stably existing in a microcrystalline silicon thin film can reduce the generation of a light-excited defect state (such as a light-induced metastablility defect). Under the high process gas pressure, diffusion of reaction gases (such as PH₃) is limited, such that the distribution of dopants (phosphorus atoms) is more uniform, local carrier traps are reduced, and uniform doping reduces carrier localization and non-radiative recombination caused by ultraviolet light (UV light). Under the high process gas pressure, the mean free path of gas molecules is shortened, the kinetic energy of high-energy particles in the plasma is reduced, excessive bombardment on the growth surface is reduced, and the film layer quality of the target sub-doped microcrystalline silicon layer is improved.

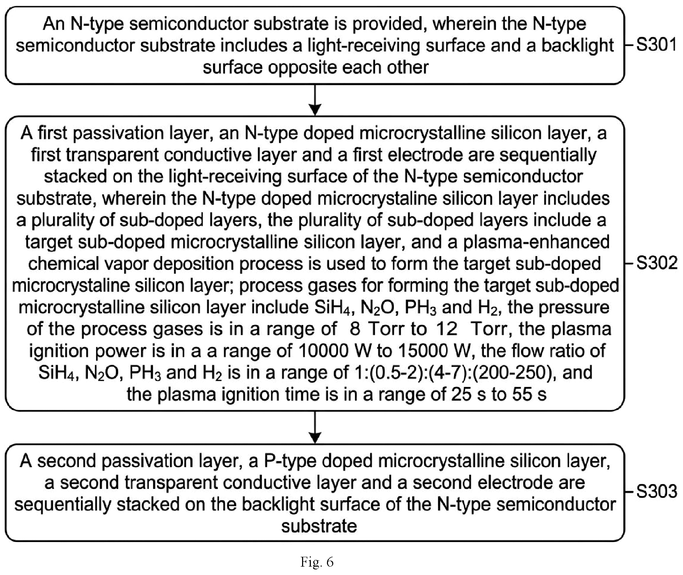

A third aspect of the embodiments of the present invention also provides a preparation method for a solar cell. Referring to Fig. 6, the preparation method includes:
step S301: an N-type semiconductor substrate is provided, wherein the N-type semiconductor substrate includes a light-receiving surface and a backlight surface opposite each other;
step S302: a first passivation layer, an N-type doped microcrystalline silicon layer, a first transparent conductive layer (105) and a first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and a plasma-enhanced chemical vapor deposition process is used to form the target sub-doped microcrystalline silicon layer; process gases for forming the target sub-doped microcrystalline silicon layer include SiH₄, N₂O, PH₃ and H₂, the pressure of the process gases is in a range of 8 Torr to 12 Torr, the plasma ignition power is in a range of 10000 W to 15000 W, the flow ratio of SiH₄, N₂O, PH₃ and H₂ is in a range of 1:(0.5-2):(4-7):(200-250), and the plasma ignition time is in a range of 25 s to 55 s; and
step S303: a second passivation layer, a P-type doped microcrystalline silicon layer, a second transparent conductive layer and a second electrode are sequentially stacked on the backlight surface of the N-type semiconductor substrate.

Forming the target sub-doped microcrystalline silicon layer satisfying requirements by using plasma-enhanced chemical vapor deposition is a complex process, and this requires cooperation of various process parameters. Upon research, it has been found that if the pressure of the process gases is too high when the target sub-doped microcrystalline silicon layer is formed, the uniformity of the target sub-doped microcrystalline silicon layer becomes poor, and the proportion of the amorphous silicon also becomes larger, such that the absorption of UV light by the target sub-doped microcrystalline silicon layer is enhanced; and although this can mitigate UV attenuation, short-circuit current loss and conversion efficiency loss are too large. On the contrary, if the pressure of the process gases is too low when the target sub-doped microcrystalline silicon layer is formed, the uniformity of the target sub-doped microcrystalline silicon layer becomes better, the proportion of amorphous silicon also becomes less; and although short-circuit current loss and conversion efficiency loss will be reduced, this is detrimental to mitigation of UV attenuation. If the plasma ignition power when forming the target sub-doped microcrystalline silicon layer is too large, although the UV attenuation can be mitigated to a certain extent, the compactness of the target sub-doped microcrystalline silicon layer may become poor, leading to a too large conversion efficiency loss; on the contrary, if the plasma ignition power when forming the target sub-doped microcrystalline silicon layer is too small, although the conversion efficiency loss can be reduced, it is not beneficial to mitigation of UV attenuation. If the flow ratio of SiH₄, N₂O, PH₃ and H₂ when forming the target sub-doped microcrystalline silicon layer is too large, especially when the flow rate of H₂ is too large, the crystallization rate of the target sub-doped microcrystalline silicon layer can be improved to some extent, and the transmittance of the target sub-doped microcrystalline silicon layer can be improved, thereby increasing the conversion efficiency, but it is not beneficial to mitigation of UV attenuation. If the flow ratio of SiH₄, N₂O, PH₃ and H₂ is too small when forming the target sub-doped microcrystalline silicon layer, especially when the flow rate of H₂ is too small, the UV attenuation can be mitigated to some extent, but the transmittance of the target sub-doped microcrystalline silicon layer will be reduced, thereby decreasing the conversion efficiency. The plasma ignition time when forming the target sub-doped microcrystalline silicon layer is related to the thickness of the target sub-doped microcrystalline silicon layer, the longer the plasma ignition time is, the larger the thickness is, and the larger the thickness of the target sub-doped microcrystalline silicon layer is; this can slightly mitigate UV attenuation, but the parasitic absorption of the target sub-doped microcrystalline silicon layer 103b will be increased, resulting in excessive short-circuit current loss and conversion efficiency loss of the solar cell. Conversely, if the thickness of the target sub-doped microcrystalline silicon layer is too small, although the parasitic absorption of the target sub-doped microcrystalline silicon layer 103b will be reduced, the short-circuit current loss and conversion efficiency loss of the solar cell are reduced. Accordingly, in the preparation method for a solar cell in the present embodiment of the present invention, the process parameters for forming the target sub-doped microcrystalline silicon layer are creatively adjusted. By using the specific process parameters in step S302, a high process gas pressure is used to form the target sub-doped microcrystalline silicon layer, and when the process gas pressure is in a range of 8 Torr to 12 Torr, under the high process gas pressure, atomic arrangement will become disordered under the high process gas pressure, and the etching effect of H atoms will be weakened; and at this time, Si atoms and H atoms will be bonded to form more amorphous structures, thus the proportion of the amorphous structures in the target sub-doped microcrystalline silicon layer becomes high, and the optical band gap of the target sub-doped microcrystalline silicon layer becomes narrow, and the crystallization rate of the formed target sub-doped microcrystalline silicon layer will be reduced, thereby improving the adsorption capability of the target sub-doped microcrystalline silicon layer on ultraviolet light (UV light), to mitigate the UV attenuation of the solar cell. However, under this high process gas pressure, the crystallization rate of the target sub-doped microcrystalline silicon layer may decrease too low, thus the carrier mobility and the light transmittance of the target sub-doped microcrystalline silicon layer are affected, thereby resulting in short-circuit current loss and conversion efficiency loss of the solar cell; furthermore, the uniformity and compactness of the target sub-doped microcrystalline silicon layer may be deteriorated, such that the extinction coefficient of the target sub-doped microcrystalline silicon layer may be increased, and the light transmittance is affected, which further results in conversion efficiency loss of the solar cell. Therefore, in the process of forming the target sub-doped microcrystalline silicon layer, the range of the plasma ignition power needs to be kept as 10000 W to 15000 W, and under the plasma ignition power, more active particles can be generated and the density of the active particles is increased, and these particles can promote the rearrangement of silicon atoms, thus the excessively low crystallization rate is improved, such that the crystallization rate of the formed target sub-doped microcrystalline silicon layer can be kept within a relatively low range (for example, 10% to 30%). Furthermore, the range of the flow ratio of SiH₄, N₂O, PH₃ and H₂ is 1:(1-3):(3-5):(200-250), and in this ratio, the dilution of hydrogen is relatively large, the deposition rate can be controlled to stabilize the uniformity of the target sub-doped microcrystalline silicon layer, so as to reduce the extinction coefficient of the target sub-doped microcrystalline silicon layer, thus the transmittance of the incident light in the target sub-doped microcrystalline silicon layer is enhanced. Furthermore, the range of the plasma ignition time is controlled to be 25 s to 55 s, to control the thickness range of the formed target sub-doped microcrystalline silicon layer, thereby reducing the parasitic absorption of incident light by the target sub-doped microcrystalline silicon layer, and further reducing short-circuit current loss and conversion efficiency loss of the solar cell.

Hereinafter, the preparation method for a solar cell of the present invention will be further described in combination with specific examples and comparative examples, but they shall not be construed as limiting the scope of protection of the present invention.

Example 5: A preparation method for a solar cell, including:
an N-type semiconductor substrate is provided, wherein the N-type semiconductor substrate includes a light-receiving surface and a backlight surface opposite each other;
a first passivation layer, an N-type doped microcrystalline silicon layer, a first transparent conductive layer (105) and a first electrode are sequentially stacked on the light-receiving surface of the N-type semiconductor substrate, wherein the N-type doped microcrystalline silicon layer includes a plurality of sub-doped layers, the plurality of sub-doped layers include a target sub-doped microcrystalline silicon layer, and a plasma-enhanced chemical vapor deposition process is used to form the target sub-doped microcrystalline silicon layer; process gases for forming the target sub-doped microcrystalline silicon layer include SiH₄, N₂O, PH₃ and H₂, the pressure of the process gases is 8 Torr, the plasma ignition power is 10000 W, the flow ratio of SiH₄, N₂O, PH₃ and H₂ is 1:0.5:4:200, and the plasma ignition time is 36 s; and
a second passivation layer, a P-type doped microcrystalline silicon layer, a second transparent conductive layer and a second electrode are sequentially stacked on the backlight surface of the N-type semiconductor substrate.

Example 6: A solar cell, which mainly differs from Example 5 in that: process gases for forming the target sub-doped microcrystalline silicon layer include SiH₄, N₂O, PH₃ and H₂, the pressure of the process gas is 10 Torr, the plasma ignition power is 12000 W, the flow ratio of SiH₄, N₂O, PH₃ and H₂ is 1:1:5:220, and the plasma ignition time is 30 s.

Example 7: A solar cell, which mainly differs from Example 5 in that: process gases for forming the target sub-doped microcrystalline silicon layer include SiH₄, N₂O, PH₃ and H₂, the pressure of the process gases is 11 Torr, the plasma ignition power is 13000 W, the flow ratio of SiH₄, N₂O, PH₃ and H₂ is 1:1.5:5:230, and the plasma ignition time is 28 s.

Example 8: A solar cell, which mainly differs from Example 5 in that: process gases for forming the target sub-doped microcrystalline silicon layer include SiH₄, N₂O, PH₃ and H₂, the pressure of the process gases is 12 Torr, the plasma ignition power is 15000 W, the flow ratio of SiH₄, N₂O, PH₃ and H₂ is 1:2:7:250, and the plasma ignition time is 25 s.

Comparative Example 5: A solar cell, which mainly differs from Example 5 in that: process gases for forming the target sub-doped microcrystalline silicon layer include SiH₄, N₂O, PH₃ and H₂, the pressure of the process gases is 7 Torr, the plasma ignition power is 12000 W, the flow ratio of SiH₄, N₂O, PH₃ and H₂ is 1:1:5:220, and the plasma ignition time is 35 s.

Comparative Example 6: A solar cell, which mainly differs from Example 5 in that: process gases for forming the target sub-doped microcrystalline silicon layer include SiH₄, N₂O, PH₃ and H₂, the pressure of the process gases is 10 Torr, the plasma ignition power is 9000 W, the flow ratio of SiH₄, N₂O, PH₃ and H₂ is 1:1:5:220, and the plasma ignition time is 35 s.

Comparative Example 7: A solar cell, which mainly differs from Example 5 in that: process gases for forming the target sub-doped microcrystalline silicon layer include SiH₄, N₂O, PH₃ and H₂, the pressure of the process gases is 10 Torr, the plasma ignition power is 16000 W, the flow ratio of SiH₄, N₂O, PH₃ and H₂ is 1:1:5:220, and the plasma ignition time is 24 s.

Comparative Example 8: A solar cell, which mainly differs from Example 5 in that: process gases for forming the target sub-doped microcrystalline silicon layer include SiH₄, N₂O, PH₃ and H₂, the pressure of the process gases is 14 Torr, the flow ratio of SiH₄, N₂O, PH₃ and H₂ is 1:1:5:220, the plasma ignition power is 12000 W, and the plasma ignition time is 24 s.

The UV attenuation, short-circuit current loss and conversion efficiency loss of the solar cells prepared in Examples 5-8 and Comparative Examples 5-8 were tested, and related parameters of the target sub-doped microcrystalline silicon layer and corresponding test results in Examples 5-8 and Comparative Examples 5-8 are shown in Table 2.

**Table 2:**

| Item | Process gas pressure (Torr) | Plasma ignition power (W) | Flow ratio of SiH₄, N₂O, PH₃ and H₂ | Plasma ignition time (S) | UV60 attenuation (%) | Short-circuit current loss (mA) | Conversion efficiency loss (%) |
|---|---|---|---|---|---|---|---|
| Example 5 | 8 | 10000 | 1:0.5:4:200 | 36 | 1.72 | 10 | 0.02 |
| Example 6 | 10 | 12000 | 1:1:5:220 | 30 | 1.45 | 12 | 0.03 |
| Example 7 | 11 | 13000 | 1:1.5:5:230 | 28 | 1.40 | 15 | 0.05 |
| Example 8 | 12 | 15000 | 1:2:7:250 | 25 | 1.38 | 20 | 0.06 |
| Comparative Example 5 | 7 | 12000 | 1:1:5:220 | 35 | 1.95 | 3 | 0.01 |
| Comparative Example 6 | 10 | 9000 | 1:1:5:220 | 35 | 1.78 | 25 | 0.08 |
| Comparative Example 7 | 10 | 16000 | 1:1:5:220 | 24 | 1.80 | 32 | 0.09 |
| Comparative Example 8 | 14 | 12000 | 1:1:5:220 | 24 | 1.35 | 60 | 0.18 |

It can be determined from Table 2 that, by using the solar cells prepared by the preparation methods in the embodiments of the present invention, the UV attenuation thereof is mitigated (less than or equal to 1.72%), and the short-circuit current loss (less than or equal to 20 mA) and the conversion efficiency loss (less than or equal to 0.06%) of the solar cells can be controlled in relatively low ranges. By comparing Comparative Examples 5-8 with Examples 5-8, it can be determined that when only one or two to three parameters among the process gas pressure, plasma ignition power, flow ratio of SiH₄, N₂O, PH₃ and H₂ and plasma ignition time are within ranges of the present invention, two undesirable situations may occur: The first situation: the UV attenuation of the solar cell is mitigated, but the short-circuit current loss and the conversion efficiency loss are relatively serious; and the second situation: the short-circuit current loss and the conversion efficiency loss of the solar cell can be controlled within relatively small ranges, but the UV attenuation is severe.

Further, it should be noted that, when step S202 and step S203 are performed or step S302 and step S303 are performed, there are multiple specific sequences of forming the N-type semiconductor substrate, the first passivation layer, the second passivation layer, the N-type doped microcrystalline silicon layer, the P-type doped microcrystalline silicon layer, the first transparent conductive layer (105), the second transparent conductive layer, the first electrode and the second electrode.

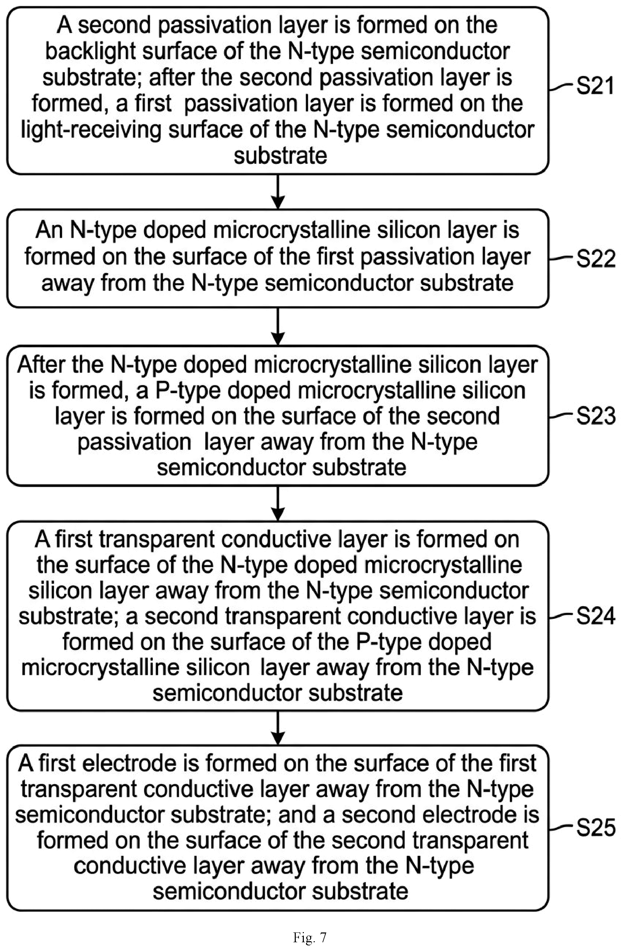

In some embodiments, with reference to Fig. 7, when step S202 and step S203 are performed or step S302 and step S303 are performed, the sequence of forming the N-type semiconductor substrate, the first passivation layer, the second passivation layer, the N-type doped microcrystalline silicon layer, the P-type doped microcrystalline silicon layer, the first transparent conductive layer (105), the second transparent conductive layer, the first electrode and the second electrode, includes:
step S21: a second passivation layer is formed on the backlight surface of the N-type semiconductor substrate; after the second passivation layer is formed, a first passivation layer is formed on the light-receiving surface of the N-type semiconductor substrate;
step S22: an N-type doped microcrystalline silicon layer is formed on the surface of the first passivation layer away from the N-type semiconductor substrate;
step S23: after the N-type doped microcrystalline silicon layer is formed, a P-type doped microcrystalline silicon layer is formed on the surface of the second passivation layer away from the N-type semiconductor substrate;
step S24: a first transparent conductive layer (105) is formed on the surface of the N-type doped microcrystalline silicon layer away from the N-type semiconductor substrate; a second transparent conductive layer is formed on the surface of the P-type doped microcrystalline silicon layer away from the N-type semiconductor substrate; and
step S25: a first electrode is formed on the surface of the first transparent conductive layer (105) away from the N-type semiconductor substrate; and a second electrode is formed on the surface of the second transparent conductive layer away from the N-type semiconductor substrate.

In some other embodiments, when step S202 and step S203 are performed or step S302 and step S303 are performed, the sequence of forming the first passivation layer, the second passivation layer, the N-type doped microcrystalline silicon layer and the P-type doped microcrystalline silicon layer may include:
the first passivation layer is formed on the light-receiving surface of the N-type semiconductor substrate;
after the first passivation layer is formed, the second passivation layer is formed on the backlight surface of the N-type semiconductor substrate;
after the second passivation layer is formed, the N-type doped microcrystalline silicon layer is formed on the surface of the first passivation layer away from the N-type semiconductor substrate; and
after the N-type doped microcrystalline silicon layer is formed, the P-type doped microcrystalline silicon layer is formed on the surface of the second passivation layer away from the N-type semiconductor substrate.

In some other embodiments, the sequence of forming the first passivation layer, the second passivation layer, the N-type doped microcrystalline silicon layer and the P-type doped microcrystalline silicon layer may include:
the first passivation layer is formed on the light-receiving surface of the N-type semiconductor substrate;
after the first passivation layer is formed, the N-type doped microcrystalline silicon layer is formed on the surface of the first passivation layer away from the N-type semiconductor substrate; and
after the N-type doped microcrystalline silicon layer is formed, the second passivation layer is formed on the backlight surface of the N-type semiconductor substrate; and
after the second passivation layer is formed, the P-type doped microcrystalline silicon layer is formed on the surface of the second passivation layer away from the N-type semiconductor substrate.

In some other embodiments, when step S202 and step S203 are performed or step S302 and step S303 are performed, the sequence of forming the first passivation layer, the second passivation layer, the N-type doped microcrystalline silicon layer and the P-type doped microcrystalline silicon layer may include:
the first passivation layer is formed on the light-receiving surface of the N-type semiconductor substrate;
after the first passivation layer is formed, the second passivation layer is formed on the backlight surface of the N-type semiconductor substrate;
after the second passivation layer is formed, the P-type doped microcrystalline silicon layer is formed on the surface of the second passivation layer away from the N-type semiconductor substrate; and
after the P-type doped microcrystalline silicon layer is formed, the N-type doped microcrystalline silicon layer is formed on the surface of the first passivation layer away from the N-type semiconductor substrate.

Hereinafter, in some embodiments, a specific process for forming the solar cell will be described in detail with reference to Figs. 5-7 and Figs. 8-14.

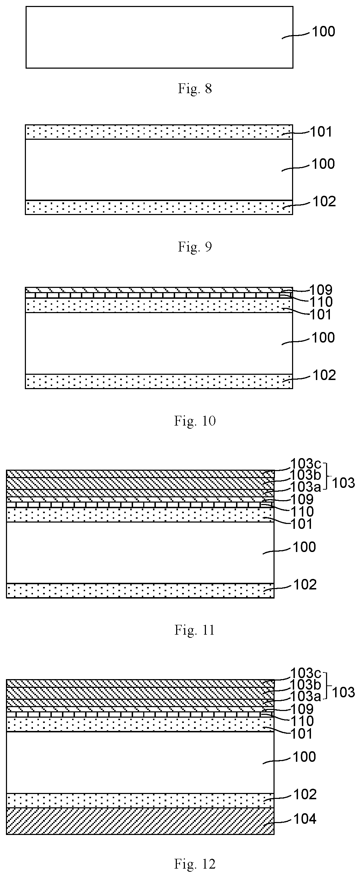

First, with reference to Fig. 5 (or Fig. 6) and in combination with Fig. 8, step S201 is performed: an N-type semiconductor substrate 100 is provided, wherein the N-type semiconductor substrate 100 includes a light-receiving surface and a backlight surface opposite each other.

Next, with continued reference to Fig. 5, step S202 and step S203 are performed (or with reference to Fig. 6, step S302 and step S303 are performed). In some embodiments, the specific process of performing step S202 and step S203 or performing step S302 and step S303 is as shown in Fig. 7. Hereinafter, the specific process of performing step S202 and step S203 or performing step S302 and step S303 is described in combination with Fig. 7.

Referring to Fig. 7 and in combination with Fig. 9, step S21 is performed: a second passivation layer 102 is formed on the backlight surface of the N-type semiconductor substrate 100; and after the second passivation layer 102 is formed, a first passivation layer 101 is formed on the light-receiving surface of the N-type semiconductor substrate 100.

In some embodiments, the first passivation layer 101 includes a plurality of first sub-passivation layers. In some embodiments, the plurality of first sub-passivation layers include a first anti-epitaxial layer, a first anti-yellow-powder layer, a first main passivation layer and a first outer layer which are sequentially stacked on the light-receiving surface of the N-type semiconductor substrate 100; wherein the material of the first anti-epitaxial layer, the first anti-yellow-powder layer and the first outer layer includes intrinsic amorphous silicon (i-a-Si:H). In some embodiments, the thickness of the first anti-epitaxial layer is in a range of 0.5 nm to 3 nm, the thickness of the first anti-yellow-powder layer is in a range of 0.1 nm to 1 nm, the thickness of the first main passivation layer is in a range of 2 nm to 6 nm, and the thickness of the first outer layer is in a range of 0.5 nm to 2 nm.

The process for forming the first passivation layer 101 includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the first passivation layer 101, , the process gases for forming the first anti-epitaxial layer include SiH₄ and N₂O, the flow ratio of SiH₄ and N₂O is in a range of 1:(1/20-1/10), the pressure of the process gases is in a range of 0.5 Torr to 0.7 Torr, the plasma ignition power is in a range of 1000 W to 2500 W, and the plasma ignition time is in a range of 1 s to 5 s. In some embodiments, in addition to N₂O, the range of the oxygen source may also be CO₂/O₂, etc.;
the process gases for forming the first anti-yellow-powder layer includes SiH₄, the flow rate of SiH₄ is in a range of 1500 sccm to 2500 sccm, the pressure of the process gases is in a range of 0.5 Torr to 0.7 Torr, the plasma ignition power is in a range of 200 W to 800 W, and the plasma ignition time is in a range of 1 s to 5 s;
the process gases for forming the first main passivation layer include SiH₄ and H₂, the flow ratio of SiH₄ and H₂ is in a range of 1:(1-4), the pressure of the process gases is in a range of 0.5 Torr to 0.7 Torr, the plasma ignition power is in a range of 500 W to 1000 W, and the plasma ignition time is in a range of 25 s to 35 s; and
the process gases for forming the first outer layer include SiH₄ and H₂, the flow ratio of SiH₄ and H₂ is in a range of 1:(1-25), the pressure of the process gases is in a range of 0.5 Torr to 0.7 Torr, the plasma ignition power is in a range of 2500 W to 5000 W, and the plasma ignition time is in a range of 8 s to 15 s.

In some embodiments, the second passivation layer 102 includes a plurality of second sub-passivation layers. In some embodiments, the plurality of second sub-passivation layers include a second anti-epitaxial layer, a second anti-yellow-powder layer, a second main passivation layer and a second outer layer which are sequentially stacked on the backlight surface of the N-type semiconductor substrate 100; wherein the material of the second anti-epitaxial layer, the second anti-yellow-powder layer and the second outer layer includes intrinsic amorphous silicon (i-a-Si:H). In some embodiments, the thickness of the second anti-epitaxial layer is in a range of 0.5 nm to 3 nm, the thickness of the second anti-yellow-powder layer is in a range of 0.1 nm to 1 nm, the thickness of the second main passivation layer is in a range of 2 nm to 6 nm, and the thickness of the second outer layer is in a range of 0.5 nm to 2 nm.

The process for forming the second passivation layer 102 includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the second passivation layer 102,, the process gases for forming the second anti-epitaxial layer include SiH₄, the flow rate of SiH₄ is in a range of 1500 sccm to 2500 sccm, the pressure of the process gases is in a range of 0.5 Torr to 0.7 Torr, the plasma ignition power is in a range of 1000 W to 2500 W, and the plasma ignition time is in a range of 2 s to 6 s;
the process gases for forming the second anti-yellow-powder layer include SiH₄, the flow rate of SiH₄ is in a range of 1500 sccm to 2500 sccm, the pressure of the process gases is in a range of 0.3 Torr to 0.5 Torr, the plasma ignition power is in a range of 200 W to 800 W, and the plasma ignition time is in a range of 2 s to 10 s;
the process gases for forming the second main passivation layer include SiH₄ and H₂, the flow ratio of SiH₄ and H₂ is in a range of 1:(1-4), the pressure of the process gases is in a range of 0.5 Torr to 0.7 Torr, the plasma ignition power is in a range of 500 W to 1000 W, and the plasma ignition time is in a range of 25 s to 50 s; and
the process gases for forming the second outer layer include SiH₄ and H₂, the flow ratio of SiH₄ and H₂ is in a range of 1:(1-25), the pressure of the process gases is in a range of 0.5 Torr to 0.7 Torr, the plasma ignition power is in a range of 2500 W to 5000 W, and the plasma ignition time is in a range of 8 s to 15 s.

In some embodiments, referring to Fig. 10, before the N-type doped microcrystalline silicon layer is formed, the method further includes: a seed layer 110 is formed on the surface of the first passivation layer 101 away from the N-type semiconductor substrate 100, wherein the material of the seed layer 110 includes microcrystalline silicon which is not doped with an oxygen element and an N-type element. and an initial transition layer 109 is formed on the surface of the seed layer 110 away from the first passivation layer 101, wherein the material of the initial transition layer 109 includes microcrystalline silicon not doped with an N-type element.

Subsequently, under a high process gas pressure, when the target sub-doped microcrystalline silicon layer 103b is formed, the crystallization rate of the formed target sub-doped microcrystalline silicon layer 103b may be reduced significantly, and the high process gas pressure will increase the extinction coefficient of the target sub-doped microcrystalline silicon layer 103b, thereby affecting the carrier mobility and light transmittance of the target sub-doped microcrystalline silicon layer, and causing serious short-circuit current loss and conversion efficiency loss of the solar cell. By forming the seed layer 110, the growth of microcrystalline silicon becomes more orderly when the N-type doped microcrystalline silicon layer 103 is subsequently formed, thus the compactness of the formed N-type doped microcrystalline silicon layer 103 is improved, and in particular, the compactness of the target sub-doped microcrystalline silicon layer 103b is improved, and the extinction coefficient of the target sub-doped microcrystalline silicon layer 103b is reduced, thereby enhancing the transmittance of long-wavelength incident light (such as red light and infrared light) in the target sub-doped microcrystalline silicon layer 103b, so as to reduce the conversion efficiency loss; moreover, the too low crystallization rate of the target sub-doped microcrystalline silicon layer 103b may be increased, so as to reduce the short-circuit current loss.

The process for forming the seed layer 110 includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the seed layer 110, process gases used when forming the seed layer 110 include SiH₄ and H₂, the pressure of the process gases is in a range of 4 Torr to 6 Torr, the plasma ignition power is in a range of 6000 W to 8000 W, the flow ratio of SiH₄ and H₂ is in a range of 1:(250-350), and the plasma ignition time is in a range of 2 s to 5 s. Under the specific process parameters, the compactness of the target sub-doped microcrystalline silicon layer 103b formed subsequently is better, and the compactness is easier to control, such that the extinction coefficient of the target sub-doped microcrystalline silicon layer formed subsequently is more easily controlled to be in a range of 0.25 to 0.45. Furthermore, when the seed layer 110 is formed, neither an oxygen element nor a phosphorus element is doped. The purpose of the seed layer 110 being not doped with the oxygen element is: the seed layer 110 is in direct contact with the first passivation layer 101, and adding the oxygen element will lead to poor contact performance of the seed layer 110 and the first passivation layer 101; and the purpose of not doping the phosphorus element is: the seed layer being doped with the phosphorus element will inhibit the crystallization process of microcrystalline silicon, resulting in an increase in the proportion of an amorphous phase (a-Si:H), hinder the growth of a microcrystalline phase with stronger conductivity, and reduce the carrier mobility; and the seed layer 110 being not doped with the phosphorus element will promote the crystallization. Furthermore, if the seed layer 110 is doped with the phosphorus element, the phosphorus element may diffuse into the first passivation layer 101, thereby affecting the passivation performance of the first passivation layer 101. The diffusion of the phosphorus element may also cause an anomalous energy band at an interface, thereby reducing the electric field intensity and affecting the carrier transport efficiency. In addition, the undoped seed layer 110 is more likely to form a fine and uniform crystal nucleus, thereby reducing lattice defects, and laying a foundation for the subsequent deposition of the N-type doped microcrystalline silicon layer 103 with a specific crystallization rate and high conductivity.

The function of the initial transition layer 109 is to serve as a carrier for subsequent deposition of the first transition layer 103a and the target sub-doped microcrystalline silicon layer 103b. By designing the seed layer 110 and the initial transition layer 109, the first transition layer 103a formed subsequently can grow well, such that the target sub-doped microcrystalline silicon layer 103b can grow well.

The process for forming the initial transition layer 109 includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the initial transition layer 109, process gases used when forming the initial transition layer 109 include SiH₄, N₂O and H₂, the pressure of the process gases is in a range of 4 Torr to 6 Torr, the plasma ignition power is in a range of 6000 W to 8000 W, the flow ratio of SiH₄, N₂O and H₂ is in a range of 1:(1-8):(250-350), and the plasma ignition time is in a range of 4 s to 10 s.

Referring to Fig. 7 and in combination with Fig. 11, step S22 is performed: an N-type doped microcrystalline silicon layer 103 is formed on the surface of the first passivation layer 101 away from the N-type semiconductor substrate 100.

In some embodiments, the N-type doped microcrystalline silicon layer 103 is formed on the initial transition layer 109 of the surface of the first passivation layer 101 away from the N-type semiconductor substrate 100, the N-type doped microcrystalline silicon layer 103 is formed on the surface of the initial transition layer 109 away from the seed layer 110.

In some embodiments, the N-type doped microcrystalline silicon layer 103 is formed, includes:
a first transition layer 103 a is formed on the surface of the initial transition layer 109 away from the seed layer 110;
the target sub-doped microcrystalline silicon layer 103b is formed on the surface of the first transition layer 103a away from the initial transition layer 109; and
a contact layer 103c is formed on the surface of the target sub-doped microcrystalline silicon layer 103b away from the first passivation layer 101.

In some embodiments, the pressure of process gases when forming the first transition layer 103a, the target sub-doped microcrystalline silicon layer 103b and the contact layer 103c is greater than the pressure of process gases when forming the seed layer 110 and the initial transition layer 109;
and the plasma ignition power when forming the first transition layer 103a, the target sub-doped microcrystalline silicon layer 103b and the contact layer 103c is greater than the pressure of process gases when forming the seed layer 110 and the initial transition layer 109;
and the hydrogen dilution ratio when forming the first transition layer 103a, the target sub-doped microcrystalline silicon layer 103b and the contact layer 103c is less than the hydrogen dilution ratio when forming the seed layer 110 and the initial transition layer 109. It should be noted that, formation of the first transition layer 103a, the target sub-doped microcrystalline silicon layer 103b and the contact layer 103c and formation of the seed layer 110 and the initial transition layer 109 may be performed in the same deposition chamber.

The process for forming the first transition layer 103a, the target sub-doped microcrystalline silicon layer 103b and the contact layer 103c includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the first transition layer 103a, the target sub-doped microcrystalline silicon layer 103b and the contact layer 103c, process gases used when forming the first transition layer 103a include SiH₄, N₂O, PH₃ and H₂, the pressure of the process gases is in a range of 8 Torr to 12 Torr and may be 8 Torr, 9 Torr, 10 Torr, 11 Torr and 12 Torr, the plasma ignition power is in a range of 10000 W to 15000 W and may be 10000 W, 11000 W, 12000 W, 13000 W, 14000 W and 15000 W, the flow ratio of SiH₄, N₂O, PH₃ and H₂ is in a range of 1:(0.5-2):(3-6):(250-300), and the plasma ignition time is in a range of 10 s to 25 s and may be 10 s, 15 s, 20 s and 25 s;
the process gases used when forming the target sub-doped microcrystalline silicon layer 103b include SiH₄, N₂O, PH₃ and H₂, the pressure of the process gases is in a range of 8 Torr to 12 Torr and may be 8 Torr, 9 Torr, 10 Torr, 11 Torr and 12 Torr, the plasma ignition power is in a range of 10000 W to 15000 W and may be 10000 W, 11000 W, 12000 W, 13000 W, 14000 W and 15000 W, the flow ratio of SiH₄, N₂O, PH₃ and H₂ is in a range of 1:(0.5-2):(4-7):(200-250), and the plasma ignition time is in a range of 25 s to 55 s and may be 25 s, 30 s, 35 s, 40 s, 45 s, 50 s and 55s; and
the process gases used when forming the contact layer 103c include SiH₄, PH₃ and H₂, the pressure of the process gases is in a range of 8 Torr to 12 Torr and may be 8 Torr, 9 Torr, 10 Torr, 11 Torr and 12 Torr, the plasma ignition power is in a range of 10000 W to 15000 W and may be 10000 W, 11000 W, 12000 W, 13000 W, 14000 W and 15000 W, the flow ratio of SiH₄, PH₃ and H₂ is in a range of 1:(5-8):(200-250), and the plasma ignition time is in a range of 8 s to 25 s and may be 8 s, 10 s, 15 s, 20 s and 25 s. It should be noted that, in addition to using PH₃, the process gases for forming the first transition layer 103a, the target sub-doped microcrystalline silicon layer 103b and the contact layer 103c may also use POCl₃, P₂O₅ or P₂O₃.

When the described specific parameters are used to form the N-type doped microcrystalline silicon layer 103 (including the first transition layer 103a, the target sub-doped microcrystalline silicon layer 103b and the contact layer 103c), the process gases use a high pressure, and when the pressure of the process gases is in a range of 8 Torr to 12 Torr, the atomic arrangement under the pressure of the process gases becomes disordered, and the etching effect of H atoms will be weakened. At this time, Si atoms and H atoms will be bonded to form more amorphous structures, thus the proportion of the amorphous structures in the N-type doped microcrystalline silicon layer 103 (especially the target sub-doped microcrystalline silicon layer 103b) becomes high, and the optical band gap of the N-type doped microcrystalline silicon layer 103 (especially the target sub-doped microcrystalline silicon layer 103b) becomes narrow, and the crystallization rate of the formed N-type doped microcrystalline silicon layer 103 (particularly the target sub-doped microcrystalline silicon layer 103b) will be reduced, thereby improving the absorption capability of the N-type doped microcrystalline silicon layer 103 (especially the target sub-doped microcrystalline silicon layer 103b) on ultraviolet light (UV light), so as to reduce ultraviolet light (UV light) reaching the first passivation layer, thereby reducing damage of the ultraviolet light (UV light) on a first intrinsic passivation layer, thereby mitigating UV attenuation. However, under this high process gas pressure, the crystallization rate of the target sub-doped microcrystalline silicon layer 103b may decrease too low, thus the carrier mobility and the light transmittance of the target sub-doped microcrystalline silicon layer 103b are affected, thereby resulting in short-circuit current loss and conversion efficiency loss of the solar cell; furthermore, the uniformity and compactness of the target sub-doped microcrystalline silicon layer 103b may be deteriorated, such that the extinction coefficient of the target sub-doped microcrystalline silicon layer 103b may be increased, and the light transmittance is affected, which further results in conversion efficiency loss of the solar cell. Therefore, in the process of forming the target sub-doped microcrystalline silicon layer 103b, the range of the plasma ignition power needs to be kept as 10000 W to 15000 W, and under the plasma ignition power, more active particles can be generated and the density of the active particles is increased, and these particles can promote the rearrangement of silicon atoms, thus the excessively low crystallization rate is improved, such that the crystallization rate of the formed target sub-doped microcrystalline silicon layer 103b can be kept within a relatively low range (for example, 10% to 30%). When the target sub-doped microcrystalline silicon layer 103b is formed, the range of the flow ratio of SiH₄, N₂O, PH₃ and H₂ is 1:(1-3):(3-5):(200-250), and in this ratio, the dilution of hydrogen is relatively large, the deposition rate can be controlled to stabilize the uniformity of the target sub-doped microcrystalline silicon layer 103b, so as to reduce the extinction coefficient of the target sub-doped microcrystalline silicon layer 103b, such that the range of the extinction coefficient is 0.25 to 0.45, thus the transmittance of the incident light in the target sub-doped microcrystalline silicon layer 103b is enhanced. When the target sub-doped microcrystalline silicon layer 103b is formed, the range of the plasma ignition time is controlled to be 25 s to 55 s, to control the thickness of the formed target sub-doped microcrystalline silicon layer 103b to be in a range of 8 nm to 12 nm, thereby reducing the parasitic absorption of incident light by the target sub-doped microcrystalline silicon layer 103b, and further reducing short-circuit current loss and conversion efficiency loss of the solar cell.

Referring to Fig. 7 and in conjunction with Fig. 12, step S23 is performed: after the N-type doped microcrystalline silicon layer 103 is formed, a P-type doped microcrystalline silicon layer 104 is formed on the surface of the second passivation layer 102 away from the N-type semiconductor substrate 100.

In some embodiments, the P-type doped microcrystalline silicon layer 104 includes a plurality of sub-layers. In some embodiments, the plurality of sub-layers include a first sub-layer, a second sub-layer and a third sub-layer which are sequentially stacked on the surface of the second passivation layer 102 away from the N-type semiconductor substrate 100; and the materials of the first sub-layer, the second sub-layer and the third sub-layer include a microcrystalline silicon layer doped with an oxygen element and a P-type element. In some embodiments, the concentrations of the P-type element in the first sub-layer, the second sub-layer and the third sub-layer gradually increase; and the thickness of the first sub-layer is in a range of 5 nm to 10 nm, the thickness of the second sub-layer is in a range of 8 nm to 15 nm, and the thickness of the third sub-layer is in a range of 8 nm to 15 nm.

In some embodiments, a second transition layer is further formed between the second passivation layer 102 and the first sub-layer, wherein the material of the second transition layer is microcrystalline silicon which is doped with an oxygen element and not doped with a P-type element.

The process for forming the P-type doped microcrystalline silicon layer 104 and the second passivation layer 102 includes: PECVD (Plasma-Enhanced Chemical Vapor Deposition), Cat-CVD (Catalytic Chemical Vapor Deposition), HDPCVD (High-Density Plasma Chemical Vapor Deposition), MPCVD (Microwave Plasma Chemical Vapor Deposition) or UHVCVD (Ultra-High Vacuum Chemical Vapor Deposition).

In some embodiments, when PECVD is used to form the P-type doped microcrystalline silicon layer 104 and the second passivation layer 102, process gases used when forming the second transition layer are SiH₄, N₂O, a second doping source and H₂, the flow ratio of SiH₄, N₂O, the second doping source and H₂ is 1:(0.12-0.16):(0.5-0.8):(250-400), the pressure of the process gases is 5 Torr to 7 Torr, the plasma ignition power is 6000 W to 10000 W, the plasma ignition time is 2 s to 10 s, and the film thickness is 0.1 to 1 nm;
the process gases used when forming the first sub-layer are SiH₄, N₂O, a second doping source and H₂, the flow ratio of SiH₄, N₂O, the second doping source and H₂ is 1:(0.08-0.12):(0.2-0.5):(200-300), the pressure of the process gases is 5 Torr to 7 Torr, the plasma ignition power is 10000 W to 15000 W, the plasma ignition time is 50 s to 100 s, and the film thickness is 5 to 10 nm;
the process gases used when forming the second sub-layer are SiH₄, N₂O, a second doping source and H₂, the flow ratio of SiH₄, N₂O, the second doping source and H₂ is 1:(0.09-0.13):(0.3-0.6):(150-250), the pressure of the process gases is 5 Torr to 7 Torr, the plasma ignition power is 10000 W to 15000 W, the plasma ignition time is 80 s to 120 s, and the film thickness is 8 to 15 nm; and
the process gases used when forming the third sub-layer are SiH₄, N₂O, a second doping source and H₂, the flow ratio of SiH₄, N₂O, the second doping source and H₂ is 1:(0.1-0.14):(0.4-0.7):(100-200), the pressure of the process gases is 5 Torr to 7 Torr, the plasma ignition power is 10000 W to 15000 W, the plasma ignition time is 80 s to 120 s, and the film thickness is 8 to 15 nm.

It should be noted that, in addition to B₂H₆, the second doping source may also be BH₃, BCl₃ or TMB or the like.

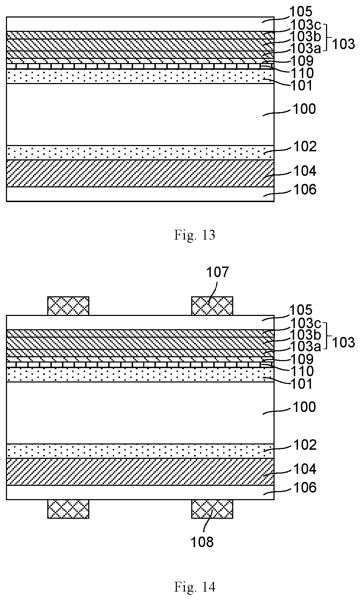

Referring to Fig. 7 and in conjunction with Fig. 13, step S24 is performed: a first transparent conductive layer (105) 105 is formed on the surface of the N-type doped microcrystalline silicon layer 103 away from the N-type semiconductor substrate 100; and a second transparent conductive layer 106 is formed on the surface of the P-type doped microcrystalline silicon layer 104 away from the N-type semiconductor substrate 100.

In some embodiments, the material of the first transparent conductive layer (105) 105 and the second transparent conductive layer 106 includes indium tin oxide (ITO) or ZnO, and the first transparent conductive layer (105) 105 and the second transparent conductive layer 106 are formed by PVD (Physical Vapor Deposition).

In some embodiments, the first transparent conductive layer (105) 105 and the second transparent conductive layer 106 may be formed simultaneously or sequentially.

Referring to Fig. 7 and in conjunction with Fig. 14, step S25 is performed: a first electrode 107 is formed on the surface of the first transparent conductive layer (105) 105 away from the N-type semiconductor substrate 100; and a second electrode 108 is formed on the surface of the second transparent conductive layer 106 away from the N-type semiconductor substrate 100.

In some embodiments, the materials of the first electrode 107 and the second electrode 108 include silver (Ag) or copper (Cu). When the material of the first electrode 107 and the second electrode 108 is silver, they are generally prepared by screen printing; and when the material of the first electrode 107 and the second electrode 108 is copper, they are generally prepared by electroplating.

A fourth aspect of embodiments of the present invention further provides a photovoltaic module, including:
cell strings, including a plurality of the solar cells as described above, or including the plurality of solar cells prepared using the preparation method for a solar cell as described above.

In the illustration of the description, the illustration of reference terms "some embodiments", "other embodiments", "ideal embodiments", etc. means that specific features, structures, materials, or characteristics described in connection with the embodiments or examples are included in at least one embodiment or example of the present invention. In the description, the illustrative expressions of the described terms do not necessarily refer to the same embodiment or example.

Various technical features of the embodiments above can be combined in any way, and in order to make the illustration brief, all possible combinations of the technical features of the embodiments above are not described. However, as long as the combinations of these technical features are not contradictory, the technical features should be considered to fall within the scope disclosed in the description.

The embodiments above merely represent several embodiments of the present invention, and the description thereof is specific and detailed, but the specific and detailed description cannot be understood as limiting the patent scope of the present invention. It should be noted that for a person of ordinary skill in the art, several modifications and improvements can be made without departing from the concept of the present invention, and all these modifications and improvements fall within the scope of protection of the present invention. Therefore, the patent scope of protection of the present invention shall be subject to the appended claims.

## Claims

1. A solar cell, comprising: an N-type semiconductor substrate (100), a first passivation layer (101), a second passivation layer (102), an N-type doped microcrystalline silicon layer (103), a P-type doped microcrystalline silicon layer (104), a first transparent conductive layer (105), a second transparent conductive layer (106), a first electrode (107) and a second electrode (108), wherein the N-type semiconductor substrate (100) comprises a light-receiving surface and a backlight surface opposite each other;
the first passivation layer (101), the N-type doped microcrystalline silicon layer (103), the first transparent conductive layer (105) and the first electrode (107) are sequentially stacked on the light-receiving surface of the N-type semiconductor substrate (100), wherein the N-type doped microcrystalline silicon layer (103) comprises a plurality of sub-doped layers, the plurality of sub-doped layers comprise a target sub-doped microcrystalline silicon layer (103b), and a crystallization rate of the target sub-doped microcrystalline silicon layer (103b) is in a range of 10% to 30%, a thickness of the target sub-doped microcrystalline silicon layer (103b) is in a range of 8 nm to 12 nm, and an extinction coefficient of the target sub-doped microcrystalline silicon layer (103b) is in a range of 0.25 to 0.45; and
the second passivation layer (102), the P-type doped microcrystalline silicon layer (104), the second transparent conductive layer (106) and the second electrode (108) are sequentially stacked on the backlight surface of the N-type semiconductor substrate (100).

2. The solar cell according to claim 1, wherein the plurality of sub-doped layers further comprise: a first transition layer (103a), located between the first passivation layer (101) and the target sub-doped microcrystalline silicon layer (103b), wherein a material of the first transition layer (103a) comprises microcrystalline silicon doped with an N-type element.

3. The solar cell according to claim 2, wherein a crystallization rate of the first transition layer (103a) is greater than the crystallization rate of the target sub-doped microcrystalline silicon layer (103b); and a thickness of the first transition layer (103a) is in a range of 3 nm to 6 nm.

4. The solar cell according to claim 3, wherein the plurality of sub-doped layers further comprise: a contact layer (103c), located between the target sub-doped microcrystalline silicon layer (103b) and the first transparent conductive layer (105), wherein a material of the contact layer (103c) comprises microcrystalline silicon which is not doped with an oxygen element and doped with an N-type element.

5. The solar cell according to claim 4, wherein the crystallization rate of the target sub-doped microcrystalline silicon layer (103b) is greater than a crystallization rate of the contact layer (103c).

6. The solar cell according to claim 5, wherein a thickness of the contact layer (103c) is in a range of 2 nm to 5 nm; or
a material of the target sub-doped microcrystalline silicon layer (103b) comprises microcrystalline silicon doped with the oxygen element and the N-type element; and a doping concentration of the N-type element in the first transition layer (103a) is less than a doping concentration of the N-type element in the target sub-doped microcrystalline silicon layer (103b), and the doping concentration of the N-type element in the target sub-doped microcrystalline silicon layer (103b) is less than a doping concentration of the N-type element in the contact layer (103c).

7. The solar cell according to claim 4 or 5, wherein the solar cell further comprises: an N-type doped amorphous silicon layer (111), located between the contact layer (103c) and the first transparent conductive layer (105), wherein a thickness of the N-type doped amorphous silicon layer (111) is in a range of 1 to 2 nm.

8. The solar cell according to any one of the preceding claims, wherein the solar cell further comprises: an initial transition layer (109), located between the N-type doped microcrystalline silicon layer (103) and the first passivation layer (101), wherein a material of the initial transition layer (109) comprises microcrystalline silicon not doped with an N-type element; and a thickness of the initial transition layer (109) is in a range of 0.2 nm-1 nm; or
the solar cell further comprises an initial transition layer (109) and a seed layer (110), the seed layer (110) is located between an initial transition layer (109) and the first passivation layer (101), the initial transition layer (109) locates between the N-type doped microcrystalline silicon layer (103) and the first passivation layer (101), and a material of the seed layer (110) comprises microcrystalline silicon which is not doped with an oxygen element and an N-type element; and a thickness of the seed layer (110) is in a range of 0.1 nm to 0.5 nm.

9. A preparation method for a solar cell, comprising:
providing an N-type semiconductor substrate (100), wherein the N-type semiconductor substrate (100) comprises a light-receiving surface and a backlight surface opposite each other;
forming a first passivation layer (101), an N-type doped microcrystalline silicon layer (103), a first transparent conductive layer (105) and a first electrode (107) which are sequentially stacked on the light-receiving surface of the N-type semiconductor substrate (100), wherein the N-type doped microcrystalline silicon layer (103) comprises a plurality of sub-doped layers, the plurality of sub-doped layers comprise a target sub-doped microcrystalline silicon layer (103b); and a plasma-enhanced chemical vapor deposition process is used to form the target sub-doped microcrystalline silicon layer (103b), and a pressure of process gases for forming the target sub-doped microcrystalline silicon layer (103b) is in a range of 8 Torr to 12 Torr; the target sub-doped microcrystalline silicon layer (103b) satisfies at least one of a first condition and a second condition, the first condition is that a crystallization rate of the target sub-doped microcrystalline silicon layer (103b) is in a range of 10% to 30%, a thickness of the target sub-doped microcrystalline silicon layer (103b) is in a range of 8 nm to 12 nm, and an extinction coefficient of the target sub-doped microcrystalline silicon layer (103b) is in a range of 0.25 to 0.45; and the second condition is that the process gases for forming the target sub-doped microcrystalline silicon layer (103b) comprise SiH₄, N₂O, PH₃ and H₂, a plasma ignition power is in a range of 10000 W to 15000 W, a flow ratio of SiH₄, N₂O, PH₃ and H₂ is in a range of 1:(0.5-2):(4-7):(200-250), and a plasma ignition time is in a range of 25 s to 55 s; and
forming a second passivation layer (102), a P-type doped microcrystalline silicon layer (104), a second transparent conductive layer (106) and a second electrode (108) which are sequentially stacked on the backlight surface of the N-type semiconductor substrate (100).

10. The preparation method for the solar cell according to claim 9, wherein before forming the N-type doped microcrystalline silicon layer (103), the preparation method for the solar cell further comprises: forming a seed layer (110) on a surface of the first passivation layer (101) away from the N-type semiconductor substrate (100), wherein a material of the seed layer (110) comprises microcrystalline silicon which is not doped with an oxygen element and an N-type element.

11. The preparation method for the solar cell according to claim 10, wherein the process gases used when forming the seed layer (110) comprise SiH₄ and H₂, a pressure of the process gases is in a range of 4 Torr to 6 Torr, a plasma ignition power is in a range of 6000 W to 8000 W, a flow ratio of SiH₄ and H₂ is in a range of 1:(250-350), and a plasma ignition time is in a range of 2 s to 5 s.

12. The preparation method for the solar cell according to claim 10 or 11, wherein the preparation method for a solar cell further comprises:
forming an initial transition layer (109) on a surface of the seed layer (110) away from the first passivation layer (101),
wherein a material of the initial transition layer (109) comprises microcrystalline silicon not doped with the N-type element; and
forming the N-type doped microcrystalline silicon layer (103) on a surface of the initial transition layer (109) away from the seed layer (110).

13. The preparation method for the solar cell according to claim 12, wherein forming the N-type doped microcrystalline silicon layer (103) on a surface of the initial transition layer (109) away from the seed layer (110), comprises:
forming a first transition layer (103a) on a surface of the initial transition layer (109) away from the seed layer (110);
forming the target sub-doped microcrystalline silicon layer (103b) on a surface of the first transition layer (103a) away from the initial transition layer (109); and
forming a contact layer (103c) on a surface of the target sub-doped microcrystalline silicon layer (103b) away from the first passivation layer (101).

14. The preparation method for the solar cell according to claim 13, wherein a pressure of the process gases when forming the first transition layer (103a), the target sub-doped microcrystalline silicon layer (103b) and the contact layer (103c) is greater than a pressure of the process gases when forming the seed layer (110) and the initial transition layer (109);
and a plasma ignition power when forming the first transition layer (103a), the target sub-doped microcrystalline silicon layer (103b) and the contact layer (103c) is greater than a plasma ignition power when forming the seed layer (110) and the initial transition layer (109);
and a hydrogen dilution ratio when forming the first transition layer (103a), the target sub-doped microcrystalline silicon layer (103b) and the contact layer (103c) is less than a hydrogen dilution ratio when forming the seed layer (110) and the initial transition layer (109).

15. The preparation method for the solar cell according to claim 14, wherein the process gases used when forming the initial transition layer (109) comprise SiH₄, N₂O and H₂, a pressure of the process gases is in a range of 4 Torr to 6 Torr, a plasma ignition power is in a range of 6000 W to 8000 W, a flow ratio of SiH₄, N₂O and H₂ is in a range of 1:(1-8):(250-350), and a plasma ignition time is in a range of 4 s to 10 s; or
the process gases for forming the initial transition layer (109) comprise SiH₄, N₂O, PH₃ and H₂, a pressure of the process gases is in a range of 8 Torr to 12 Torr, a plasma ignition power is in a range of 10000 W to 15000 W, a flow ratio of SiH₄, N₂O, PH₃ and H₂ is in a range of 1:(0.5-2):(3-6):(250-300), and a plasma ignition time is in a range of 10 s to 25 s; or
the process gases when forming the contact layer (103c) comprise SiH₄, PH₃ and H₂, a pressure of the process gases is in a range of 8 Torr to 12 Torr, a plasma ignition power is in a range of 10000 W to 15000 W, a flow ratio of SiH₄, PH₃ and H₂ is in a range of 1:(5-8):(200-250), and a plasma ignition time is in a range of 8 s to 25 s.
